# EUROPEAN PATENT APPLICATION

(11) **EP 4 525 577 A1**
(43) Date of publication of application: **19.03.2025**
(21) Application number: 23856170.8
(22) Date of filing: 01.06.2023
(51) Int. Cl.: H05K 7/20

(54) **HEAT DISSIPATION MODULE AND ELECTRONIC DEVICE**

(30) Priority: 22.08.2022 CN 202211008861
(71) Applicant: xFusion Digital Technologies Co., Ltd., Zhengzhou, Henan 450046 (CN)
(72) Inventor: XIAO, Minqi, Zhengzhou, Henan 450046 (CN); ZHANG, Zilin, Zhengzhou, Henan 450046 (CN)
(74) Representative: MERH-IP Matias Erny Reichl Hoffmann Patentanwälte PartG mbB
(86) International application number: PCT/CN2023/097848
(87) International publication number: WO 2024/041078

(57) **Abstract**

Embodiments of this application provide a heat dissipation module and an electronic device, and relate to the field of heat dissipation technologies. The heat dissipation module includes a first cooling pipeline, a second cooling pipeline, a first cold plate, a second cold plate, at least one heat pipe, a first cold plate bracket, and a second cold plate bracket. The first cooling pipeline is configured to input a cooling working substance, and the second cooling pipeline is configured to output the cooling working substance. The first cold plate bracket is configured to support the first cold plate, and the second cold plate bracket is configured to support the second cold plate. The first cold plate communicates with the first cooling pipeline and the second cooling pipeline. A contact surface of the first cold plate is in contact with a to-be-heat-dissipated part, and is configured to absorb heat on the to-be-heat-dissipated part. The second cold plate communicates with the first cooling pipeline and the second cooling pipeline. The second cold plate is disposed at an interval from the first cold plate. The heat pipe is connected to the first cold plate and the second cold plate. The heat dissipation module provided in the embodiments of this application may be applied to an electronic device, to perform heat dissipation for the electronic device.

## Description

This application claims priority to Chinese Patent Application No. 202211008861.5, filed with the China National Intellectual Property Administration on August 22, 2022 and entitled "HEAT DISSIPATION MODULE AND ELECTRONIC DEVICE", which is incorporated herein by reference in its entirety.

### TECHNICAL FIELD

This application relates to the field of heat dissipation technologies, and in particular, to a heat dissipation module and an electronic device.

### BACKGROUND

When an electronic device works, a relatively large amount of heat is generated. To avoid a case in which normal working of the electronic device is affected due to an excessively high temperature, a heat dissipation apparatus needs to be used to perform heat dissipation for the electronic device.

### SUMMARY

An objective of embodiments of this application is to provide a heat dissipation module and an electronic device, to reduce thermal resistance in the heat dissipation module and improve a heat dissipation effect of the heat dissipation module.

To achieve the foregoing objective, the embodiments of this application provide the following technical solutions.

According to an aspect, an embodiment of this application provides a heat dissipation module and an electronic device, and relates to the field of heat dissipation technologies. The heat dissipation module includes a first cooling pipeline, a second cooling pipeline, a first cold plate bracket, a second cold plate bracket, a first cold plate, a second cold plate, and at least one heat pipe. The first cooling pipeline is configured to input a cooling working substance, and the second cooling pipeline is configured to output the cooling working substance. The first cold plate bracket is configured to support the first cold plate, and the second cold plate bracket is configured to support the second cold plate.

The first cold plate communicates with the first cooling pipeline and the second cooling pipeline. A contact surface of the first cold plate is in contact with a to-be-heat-dissipated part, and is configured to absorb heat on the to-be-heat-dissipated part. The second cold plate communicates with the first cooling pipeline and the second cooling pipeline. The second cold plate is disposed at an interval from the first cold plate. The heat pipe is connected to the first cold plate and the second cold plate.

In this embodiment of this application, the contact surface of the first cold plate may be in contact with the to-be-heat-dissipated part. Therefore, heat on the to-be-heat-dissipated part may be transferred to the first cold plate. For example, the heat on the to-be-heat-dissipated part may be transferred to the first cold plate through the contact surface of the first cold plate. In addition, the first cold plate communicates with the first cooling pipeline and the second cooling pipeline. Therefore, in a use process, the cooling working substance may flow into the first cold plate through the first cooling pipeline, absorb heat on the first cold plate, and then be discharged to the outside of the first cold plate through the second cooling pipeline. That is, as the cooling working substance flows, heat generated by the to-be-heat-dissipated part may be released through the first cold plate and the cooling working substance flowing through the first cold plate, to implement heat dissipation for the to-be-heat-dissipated part. The cooling working substance may be any one or more of water, 25% propylene glycol, or 25% ethylene glycol.

The second cold plate is connected to the first cold plate through the at least one heat pipe. That is, an end that is of the heat pipe and that is connected to the first cold plate may absorb some heat on the first cold plate, and the some heat may be released to the second cold plate through an end that is of the heat pipe and that is connected to the second cold plate. Therefore, the second cold plate and the heat pipe are disposed, to further reduce heat on the first cold plate, so as to implement better heat dissipation for the to-be-heat-dissipated part. Therefore, the heat pipe may be used, so that the second cold plate can share heat that is on the to-be-heat-dissipated part and that is absorbed by the first cold plate. Therefore, this helps reduce thermal resistance (that is, a ratio of a temperature difference between an inlet and an outlet of the first cold plate to power of the to-be-heat-dissipated part) of the first cold plate, and improves a heat dissipation effect on the to-be-heat-dissipated part.

In addition, the second cold plate is disposed at an interval from the first cold plate, to avoid a case in which a heat dissipation effect of the first cold plate is affected because the second cold plate is in direct contact with the first cold plate and heat on the second cold plate may be transferred to the first cold plate. Furthermore, this can further ensure that the heat on the second cold plate is not prone to affect the to-be-heat-dissipated part.

In addition, the second cold plate further communicates with the first cooling pipeline and the second cooling pipeline. Therefore, in a use process, the cooling working substance may further flow into the second cold plate through the first cooling pipeline, absorb heat on the second cold plate, and then be discharged to the outside of the second cold plate through the second cooling pipeline. That is, as the cooling working substance flows, the heat on the second cold plate may be released through the cooling working substance flowing through the second cold plate, to implement heat dissipation for the second cold plate. In this case, a heat dissipation effect on the first cold plate and the to-be-heat-dissipated part may also be improved. Therefore, this helps further reduce the thermal resistance of the first cold plate, and improves the heat dissipation effect on the to-be-heat-dissipated part.

In some embodiments, the second cold plate is located on a side that is of the first cold plate and that faces away from the contact surface. Such an arrangement helps reduce space occupation in a direction parallel to the contact surface, and can further ensure that the heat on the second cold plate is not prone to affect the to-be-heat-dissipated part.

In some embodiments, any heat pipe includes a first pipe section and a second pipe section that are sequentially connected. The first pipe section is in contact with the first cold plate, and the second pipe section is in contact with the second cold plate. Therefore, some heat on the first cold plate may be absorbed by using the first pipe section, and then the some heat may be released to the second cold plate by using the second pipe section. The first pipe section may be an evaporator section of the heat pipe. The second pipe section may be a condenser section of the heat pipe.

In such an arrangement, the heat pipe may be used, so that the second cold plate can share heat that is on the to-be-heat-dissipated part and that is absorbed by the first cold plate, to further reduce heat on the first cold plate, so as to implement better heat dissipation for the to-be-heat-dissipated part.

In some embodiments, the contact surface of the first cold plate includes a recessed region, and the first pipe section is located in the recessed region. In such an arrangement, the first pipe section may be better fastened, so that the first pipe section of the heat pipe is in contact with the contact surface of the first cold plate, and the first pipe section can better absorb the heat that is on the to-be-heat-dissipated part and that is absorbed by the first cold plate. In addition, a case in which a pipe diameter length of the first pipe section affects contact between the contact surface and the to-be-heat-dissipated part is avoided, so that the first pipe section of the heat pipe can better absorb the heat that is on the to-be-heat-dissipated part and that is absorbed by the first cold plate. This can also help subsequently conduct the some heat to the second cold plate, to jointly perform heat dissipation for the to-be-heat-dissipated part by using the first cold plate and the second cold plate, and improve a heat dissipation effect of the heat dissipation module.

In some embodiments, the heat dissipation module further includes the first cold plate bracket. The first cold plate bracket includes a first hollow region and a first connection portion surrounding the first hollow region. The first cold plate is mounted in the first hollow region.

In such an arrangement, the first cold plate is mounted in the first hollow region, so that the first connection portion surrounds the first cold plate. In addition, a side that is of the first connection portion and that is away from the first cold plate may be configured to be connected to an external structure. Therefore, the first cold plate may be fastened by using the first cold plate bracket, to help improve structural stability of the heat dissipation module.

In some embodiments, the heat dissipation module further includes the second cold plate bracket. The second cold plate bracket includes a second hollow region and a second connection portion surrounding the second hollow region. The second cold plate is mounted in the second hollow region.

In such an arrangement, the second cold plate is mounted in the second hollow region, so that the second connection portion surrounds the second cold plate. In addition, a side that is of the second connection portion and that is away from the second cold plate may be configured to be connected to an external structure. Therefore, the second cold plate may be fastened by using the second cold plate bracket, to help improve structural stability of the heat dissipation module.

In some embodiments, the first cold plate bracket further includes a first heat pipe mounting hole extending from a first side surface of the first cold plate bracket to the first hollow region. The first pipe section extends into the first hollow region through the first heat pipe mounting hole, so that the first pipe section is in contact with the first cold plate.

In such an arrangement, the first heat pipe mounting hole extends from the first side surface of the first cold plate bracket to the first hollow region, that is, one end of the first heat pipe mounting hole runs through the first side surface of the first cold plate bracket, so that the external heat pipe can extend into the inside of the first cold plate bracket through the first heat pipe mounting hole. In addition, the other end of the first heat pipe mounting hole extends to the first hollow region, so that the first pipe section of the heat pipe can extend into the first hollow region through the first heat pipe mounting hole, and be in direct contact with the first cold plate mounted in the first hollow region, and the first pipe section can better absorb the heat that is on the to-be-heat-dissipated part and that is absorbed by the first cold plate.

Therefore, the first pipe section of the heat pipe can absorb some heat on the first cold plate, and conduct the some heat to the second cold plate. This achieves an effect of simultaneously performing heat dissipation for the to-be-heat-dissipated part by using the first cold plate and the second cold plate, and improves heat dissipation performance of the heat dissipation module.

In some embodiments, the first cold plate bracket further includes a first extension hole, the first extension hole extends from the first hollow region to a direction facing away from the first side surface, and an axis of the first extension hole coincides with an axis of the first heat pipe mounting hole.

In such an arrangement, the first pipe section may sequentially extend into the first extension hole through the first heat pipe mounting hole and the first hollow region. That is, two ends of the first pipe section may separately protrude from the first hollow region, to further fasten the first pipe section, so as to avoid a problem that the first pipe section sinks due to gravity of the first pipe section.

In some embodiments, the second cold plate bracket further includes a second heat pipe mounting hole extending from a second side surface of the second cold plate bracket to the second hollow region. The second pipe section extends into the second hollow region through the second heat pipe mounting hole, so that the second pipe section is in contact with the second cold plate.

In such an arrangement, the second heat pipe mounting hole extends from the second side surface of the second cold plate bracket to the second hollow region, that is, one end of the second heat pipe mounting hole runs through the second side surface of the second cold plate bracket, so that the external heat pipe can extend into the inside of the second cold plate bracket through the second heat pipe mounting hole. In addition, the other end of the second heat pipe mounting hole extends to the second hollow region, so that the second pipe section of the heat pipe can extend into the second hollow region through the second heat pipe mounting hole, and be in direct contact with the second cold plate mounted in the second hollow region, and the second pipe section can release the heat absorbed from the first cold plate to the second cold plate.

Therefore, an effect of simultaneously performing heat dissipation for the to-be-heat-dissipated part by using the first cold plate and the second cold plate is achieved, and heat dissipation performance of the heat dissipation module is improved.

In some embodiments, the second cold plate bracket further includes a second extension hole, the second extension hole extends from the second hollow region to a direction facing away from the third side surface, and an axis of the second extension hole coincides with an axis of the second heat pipe mounting hole.

In such an arrangement, the second pipe section may sequentially extend into the second extension hole through the second heat pipe mounting hole and the second hollow region. That is, two ends of the second pipe section may separately protrude from the second hollow region, to further fasten the second pipe section, so as to avoid a problem that the second pipe section sinks due to gravity of the second pipe section.

In some embodiments, the heat dissipation module further includes a third cooling pipeline. An inlet of the first cold plate communicates with the first cooling pipeline, an outlet of the first cold plate communicates with an inlet of the second cold plate through the third cooling pipeline, and an outlet of the second cold plate communicates with the second cooling pipeline.

In such an arrangement, the second cold plate and the first cold plate may be connected in series between the first cooling pipeline and the second cooling pipeline. Therefore, the first cold plate and the second cold plate may be connected in series to simultaneously perform heat dissipation for the to-be-heat-dissipated part. When two cold plates are connected in series to perform heat dissipation for the to-be-heat-dissipated part, a relatively good heat dissipation effect can be achieved by using a relatively low flow rate of a cooling working substance in the cold plate. In addition, when the flow rate of the cooling working substance in the cold plate in the heat dissipation module is decreased, a pressure drop at an inlet and an outlet in the cold plate may be decreased accordingly. Therefore, a heat dissipation effect of the cold plate can be improved, that is, this can help improve the heat dissipation effect of the heat dissipation module.

In some embodiments, the first cooling pipeline includes a first branch pipe, a second branch pipe, and a first main pipe. One end of the first branch pipe and one end of the second branch pipe communicate with the first main pipe. The second cooling pipeline includes a third branch pipe, a fourth branch pipe, and a second main pipe. One end of the third branch pipe and one end of the fourth branch pipe communicate with the second main pipe. An inlet of the first cold plate communicates with the other end of the first branch pipe, and an outlet of the first cold plate communicates with the other end of the third branch pipe. An inlet of the second cold plate communicates with the other end of the second branch pipe, and an outlet of the second cold plate communicates with the other end of the fourth branch pipe.

In such an arrangement, the second cold plate and the first cold plate may be connected in parallel between the first cooling pipeline and the second cooling pipeline. Therefore, the first cold plate and the second cold plate may be connected in parallel to simultaneously perform heat dissipation for the to-be-heat-dissipated part. When two cold plates are connected in parallel to perform heat dissipation for the to-be-heat-dissipated part, a total flow rate of the cooling working substance in the heat dissipation module can be distributed to the two cold plates, that is, a flow rate of the cooling working substance in any one cold plate can be decreased, and a pressure drop in the heat dissipation module can be relatively decreased, to help improve the heat dissipation effect of the heat dissipation module.

In some embodiments, the heat pipe further includes a third pipe section, and the third pipe section communicates between the first pipe section and the second pipe section. The first cold plate includes a first edge and a second edge that are opposite to each other. The third pipe section is located on a side that is of the first edge and that is away from the second edge. In such an arrangement, third pipe sections of a plurality of heat pipes are concentrated on one side edge of the first cold plate. This can reduce a volume of the heat dissipation module, and facilitate miniaturization of the heat dissipation module.

In some embodiments, there are a plurality of heat pipes. The plurality of heat pipes are disposed at an interval in an extension direction of one side edge of the first cold plate. For example, the plurality of heat pipes are sequentially disposed at an interval in an extension direction of the first edge. In such an arrangement, the heat on the first cold plate is conducted to the second cold plate by using the plurality of heat pipes, to increase a heat conduction area between the heat pipe and each of the first cold plate and the second cold plate. This can help shorten a heat dissipation time required for conducting the heat on the first cold plate to the second cold plate, and improve heat conduction efficiency. That is, a heat dissipation time required by the heat dissipation module is shortened, and the heat dissipation effect of the heat dissipation module is improved.

In some embodiments, a plane parallel to the contact surface is used as a reference plane. An orthographic projection of the second cold plate on the reference plane coincides with an orthographic projection of the first cold plate on the reference plane. Herein, coincidence includes absolute coincidence and approximate coincidence. That is, if a floating range of a gap between the orthographic projection of the first cold plate on the reference plane and the orthographic projection of the second cold plate on the reference plane does not exceed an error threshold, it may be considered that edges of the two pipe sections approximately "coincide".

In such an arrangement, the heat dissipation module has a simple structure. This can help concentrate structures in the heat dissipation module, and reduce space occupation of the heat dissipation module in the direction parallel to the contact surface.

In some embodiments, there are a plurality of second cold plates. The plurality of second cold plates are sequentially arranged at an interval in a direction away from the first cold plate. In such an arrangement, the heat dissipation module may include three or more cold plates. A plurality of cold plates are used to simultaneously perform heat dissipation for the to-be-heat-dissipated part. This can help reduce thermal resistance in the heat dissipation module, and improve the heat dissipation effect of the heat dissipation module.

In some embodiments, the heat pipe includes a pipe shell, a wick, and a working substance. The wick is located on an inner wall of the pipe shell, and the working substance is located in the pipe shell. In such an arrangement, the first pipe section of the heat pipe is in contact with the first cold plate. When the first pipe section of the heat pipe is heated, the working substance in the wick in the first pipe section evaporates and vaporizes, the vapor flows to the second pipe section to release heat and condense into liquid, and then the liquid flows back to the first pipe section along the wick under capillary action. This is repeated to conduct the heat on the first cold plate to the second cold plate.

In some embodiments, the first cold plate includes a first housing and a first fin assembly, the first housing has a first accommodating cavity, and the first fin assembly is located in the first accommodating cavity.

In such an arrangement, the first cold plate includes the first fin assembly. This can help improve the heat dissipation effect of the first cold plate, that is, this can help improve the heat dissipation effect of the heat dissipation module.

In some embodiments, the second cold plate includes a second housing and a second fin assembly, the second housing has a second accommodating cavity, and the second fin assembly is located in the second accommodating cavity.

In such an arrangement, the second cold plate includes the second fin assembly. This can help improve a heat dissipation effect of the second cold plate, that is, this can help improve the heat dissipation effect of the heat dissipation module.

According to another aspect, an embodiment of this application provides an electronic device. The electronic device includes at least one to-be-heat-dissipated part and at least one heat dissipation module described above. A contact surface of a first cold plate in the heat dissipation module is in contact with the at least one to-be-heat-dissipated part. The to-be-heat-dissipated part may be a chip.

In some embodiments, when the electronic device includes one heat dissipation module, the one heat dissipation module may be used to perform heat dissipation for one to-be-heat-dissipated part.

In some embodiments, when the electronic device includes at least two heat dissipation modules disposed in series, a plurality of heat dissipation modules may be used to simultaneously perform heat dissipation for one to-be-heat-dissipated part, or it may be set that one of a plurality of heat dissipation modules performs heat dissipation for one or more to-be-heat-dissipated parts.

The electronic device provided in this embodiment of this application includes the foregoing heat dissipation module, and therefore has all the foregoing beneficial effects. Details are not described herein again.

In some embodiments, an area of the contact surface of the first cold plate in the heat dissipation module is greater than or equal to an area of a surface that is of one of the to-be-heat-dissipated part and that is close to the heat dissipation module.

In such an arrangement, the surface that is of the to-be-heat-dissipated part and that is close to the heat dissipation module may be in complete contact with the contact surface of the first cold plate in the heat dissipation module. This helps increase a contact area between the heat dissipation module and the to-be-heat-dissipated module, improves a heat dissipation effect of the heat dissipation module on the to-be-heat-dissipated part, and improves heat dissipation performance of the heat dissipation module.

### BRIEF DESCRIPTION OF DRAWINGS

FIG. 1 is a schematic diagram of a structure of an electronic device according to some embodiments of this application;
FIG. 2A is a schematic diagram of a structure of a heat dissipation module according to some embodiments of this application;
FIG. 2B is a schematic diagram of a structure of a heat dissipation module according to some other embodiments of this application;
FIG. 2C is a schematic diagram of a structure of two heat dissipation modules connected in series according to some embodiments of this application;
FIG. 2D is a schematic diagram of a structure of two heat dissipation modules connected in series according to some other embodiments of this application;
FIG. 3A is a plan view of a structure shown in a dashed line box in FIG. 2A from a first perspective V;
FIG. 3B is a plan view of a structure shown in a dashed line box in FIG. 2B from a first perspective V;
FIG. 4A is a schematic assembly diagram of a to-be-heat-dissipated part, a first pipe section, and a first cold plate in FIG. 2A;
FIG. 4B is a cross-sectional view in a direction J-J' in FIG. 2A;
FIG. 4C is a schematic assembly diagram of a first cold plate bracket and a first pipe section of a heat pipe in FIG. 2A;
FIG. 4D is another cross-sectional view in a direction J-J' in FIG. 2A;
FIG. 4E is another schematic assembly diagram of a first cold plate bracket and a first pipe section of a heat pipe in FIG. 2A;
FIG. 5A is a schematic diagram of a structure of a heat dissipation module with a plurality of second cold plates according to some embodiments of this application;
FIG. 5B is a schematic diagram of a structure of a heat dissipation module with a plurality of second cold plates according to some other embodiments of this application;
FIG. 6A is a schematic diagram of a structure of a first cold plate in FIG. 2A;
FIG. 6B is a cross-sectional view in a direction F-F' in FIG. 6A; and
FIG. 7 is a schematic diagram of a structure of a heat pipe in FIG. 2A.

### DESCRIPTION OF EMBODIMENTS

The following clearly and comprehensively describes the technical solutions in some embodiments of this application with reference to the accompanying drawings. Clearly, the described embodiments are merely some rather than all of embodiments of this application. All other embodiments obtained by a person of ordinary skill in the art based on the embodiments provided in this application shall fall within the protection scope of this application.

Unless the context requires otherwise, the term "comprise (comprise)" and other forms thereof such as the third-person singular form "comprises (comprises)" and the present participle form "comprising (comprising)" throughout the specification and claims are construed as an open and inclusive meaning, that is, "including but not limited to". In the descriptions of the specification, the terms such as "one embodiment (one embodiment)", "some embodiments (some embodiments)", "exemplary embodiments (exemplary embodiments)", "example (example)", "specific example (specific example)", or "some examples (some examples)" are intended to indicate that specific features, structures, materials, or characteristics related to the embodiment or example are included in at least one embodiment or example of this application. Schematic representations of the foregoing terms do not necessarily refer to a same embodiment or example. In addition, the specific features, structures, materials, or characteristics may be included in any one or more embodiments or examples in any suitable manner.

The following terms "first" and "second" are used only for the purpose of description, and shall not be understood as an indication or implication of relative importance or an implicit indication of a quantity of indicated technical features. Therefore, a feature limited by "first" or "second" may explicitly or implicitly include one or more features. In the descriptions of the embodiments of this application, unless otherwise specified, "a plurality of" means two or more.

When some embodiments are described, "connected", "connect", and derived expressions thereof may be used. For example, when some embodiments are described, the term "connected" may be used to indicate that two or more parts are in direct or indirect physical contact with each other. For example, if A and B are connected, it may indicate that A and B are connected, or it may indicate that A and B are connected through another part.

The phrase "at least one of A, B and C" and the phrase "at least one of A, B or C" have a same meaning, and both include the following combinations of A, B, and C: only A, only B, only C, a combination of A and B, a combination of A and C, a combination of B and C, and a combination of A, B, and C.

The phrase "A and/or B" includes the following three combinations: only A, only B, and a combination of A and B.

As used herein, the term "about", "substantially", or "approximately" includes a stated value and an average value within an acceptable deviation range of a specific value. The acceptable deviation range is, for example, determined by a person of ordinary skill in the art while considering measurement in question and errors associated with measurement of a specific quantity (that is, limitations of a measurement system).

As used herein, the term "parallel", "perpendicular", or "equal" includes a stated situation and a situation similar to the stated situation, and a range of the similar situation is within an acceptable deviation range. The acceptable deviation range is, for example, determined by a person of ordinary skill in the art while considering measurement in question and errors associated with measurement of a specific quantity (that is, limitations of a measurement system). For example, "parallel" includes absolutely parallel and approximately parallel, and an acceptable deviation range for approximately parallel may be, for example, a deviation within 5°. "Perpendicular" includes absolutely perpendicular and approximately perpendicular, and an acceptable deviation range for approximately perpendicular may be, for example, a deviation within 5°. "Equal" includes absolutely equal and approximately equal, and an acceptable deviation range for approximately equal may be, for example, that a difference between two objects that are equal to each other is less than or equal to 5% of either of the two objects.

Exemplary embodiments are described herein with reference to cross-sectional views and/or plan views used as idealized exemplary accompanying drawings. In the accompanying drawings, thicknesses of layers and regions are enlarged for clarity. Therefore, variations in shape with respect to the accompanying drawings due to, for example, manufacturing technologies and/or tolerances may be envisaged. Therefore, the exemplary embodiments should not be construed to be limited to the shapes of the regions shown herein, but to include deviations in shape due to, for example, manufacturing. For example, an etched region shown in a rectangular shape usually has a feature of being curved. Therefore, the regions shown in the accompanying drawings are schematic in nature, and their shapes are not intended to show actual shapes of the regions in a device, and are not intended to limit the scope of the exemplary embodiments.

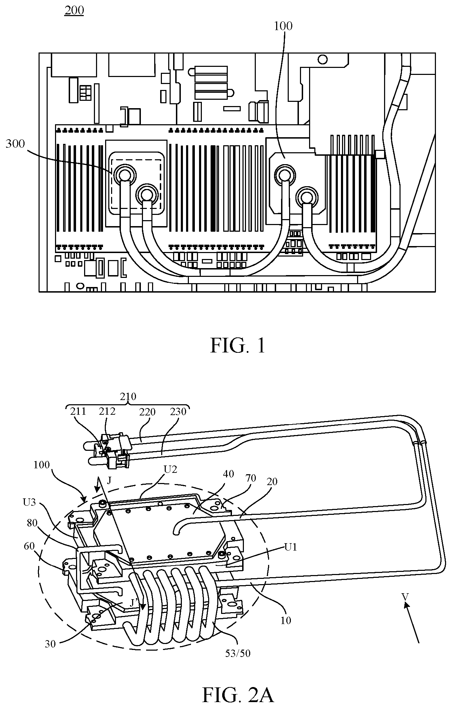

FIG. 1 is a schematic diagram of a structure of an electronic device according to some embodiments of this application.

An embodiment of this application provides an electronic device 200. As shown in FIG. 1, the electronic device 200 includes at least one to-be-heat-dissipated part 300 and at least one heat dissipation module 100. A contact surface of a cold plate in the heat dissipation module 100 is in contact with at least one to-be-heat-dissipated part. Therefore, heat on the to-be-heat-dissipated part 300 may be absorbed by using a cooling working substance in the cold plate in the heat dissipation module 100, and then the cooling working substance is output from the cold plate, that is, the absorbed heat is dissipated, to implement heat dissipation for the to-be-heat-dissipated part 300.

In some embodiments, the electronic device 200 may be a server or a communication device.

In some embodiments, the to-be-heat-dissipated part 300 may be a chip, a central processing unit (English full name: Central Processing Unit, CPU for short), an accelerated processing unit (English full name: Accelerated Processing Unit, APU for short), a graphics processing unit (English full name: Graphics Processing Unit, GPU for short), or the like.

In some embodiments, as shown in FIG. 1, in the electronic device 200, an area of a contact surface of a first cold plate in the heat dissipation module 100 is greater than or equal to an area of a surface that is of one of the to-be-heat-dissipated part 300 and that is close to the heat dissipation module 100.

In such an arrangement, the heat dissipation module 100 may completely cover the to-be-heat-dissipated part 300, may be in full contact with the to-be-heat-dissipated part 300, and better absorb heat on the to-be-heat-dissipated part 300. That is, this can help improve a heat dissipation effect of the heat dissipation module 100 in the electronic device 200 on the to-be-heat-dissipated part 300, to avoid a case in which a service life of the electronic device 200 is affected due to an excessively high temperature of the to-be-heat-dissipated part 300.

In FIG. 1, an example in which the area of the contact surface of the first cold plate in the heat dissipation module 100 is greater than the area of the surface that is of one of the to-be-heat-dissipated part 300 and that is close to the heat dissipation module 100 is used for illustration. It may be understood that in some other embodiments, it may alternatively be set that the area of the contact surface of the first cold plate in the heat dissipation module 100 is equal to the area of the surface that is of one of the to-be-heat-dissipated part 300 and that is close to the heat dissipation module 100. This is not limited in this disclosure.

The following provides descriptions by using an example in which the to-be-heat-dissipated part 300 is a chip. When the chip 300 works, power consumption is relatively high. Consequently, when the chip 300 is used, an amount of heat is relatively large, affecting the service life of the electronic device 200. The contact surface of the cold plate in the heat dissipation module 100 is disposed to face the chip 300. Therefore, the heat dissipation module 100 can be used to perform heat dissipation for the chip 300, to avoid a case in which a service life of the chip 300 is affected due to an excessively high temperature, and improve quality of the electronic device 200.

In some embodiments, as shown in FIG. 1, an example in which the electronic device 200 includes one chip 300 is used in FIG. 1 for illustration. The chip 300 may be located below the heat dissipation module 100, that is, the chip 300 is covered by the heat dissipation module 100. However, an example in which the electronic device 200 includes one chip 300 is used in FIG. 1 for illustration. Therefore, the one chip 300 may be located below a heat dissipation module 100 on the left shown in FIG. 1, or may be located below a heat dissipation module 100 on the right. This is not limited in this disclosure.

In such an arrangement, a contact surface of a cold plate in the heat dissipation module 100 may be used to be in contact with the chip 300, and the heat dissipation module 100 may be used to absorb heat on the chip 300 and release the some heat. Therefore, effective heat dissipation can be performed for the chip 300, to avoid a case in which a service life of the chip 300 is affected due to an excessively high temperature, and improve quality of the electronic device 200.

In some other embodiments, the electronic device 200 includes a plurality of (for example, two or more) chips 300. It may be set that one heat dissipation module 100 performs heat dissipation for one chip 300. Alternatively, it may be set that one heat dissipation module 100 simultaneously performs heat dissipation for a plurality of chips 300. For example, when the electronic device 200 includes two heat dissipation modules 100 and four chips 300, one heat dissipation module 100 may be used to be in contact with two chips 300, that is, one heat dissipation module 100 is used to simultaneously perform heat dissipation for two chips 300. This is not limited in this application, provided that a case in which the service life of the electronic device 200 is affected due to a high temperature of the chip 300 can be avoided when the heat dissipation module 100 is used to perform heat dissipation for the chip 300.

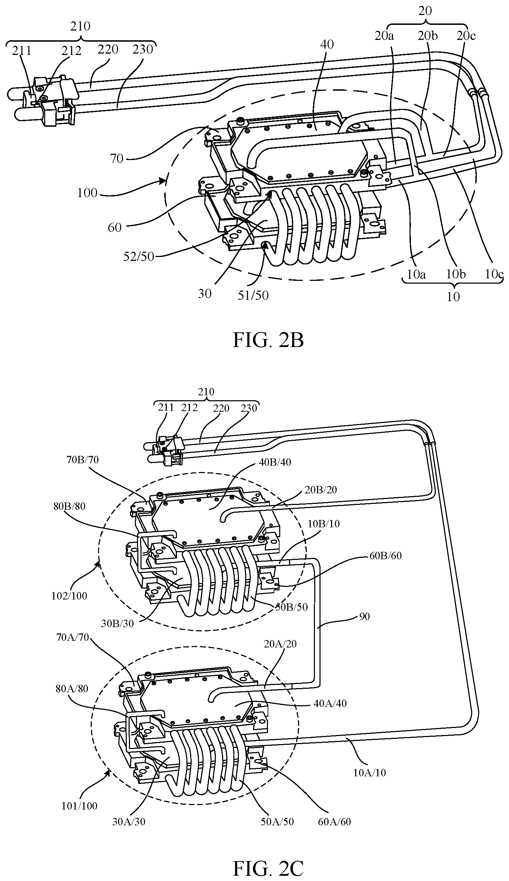

A quantity of chips 300 for which heat dissipation needs to be performed in the electronic device 200 is not limited in this disclosure. A corresponding quantity of heat dissipation modules 100 may be disposed based on different quantities of chips. Specifically, the following describes a quantity of heat dissipation modules 100 in the electronic device. First, with reference to FIG. 2A and FIG. 2B, the following provides descriptions by using an example in which the electronic device 200 includes one heat dissipation module 100.

FIG. 2A is a schematic diagram of a structure of a heat dissipation module according to some embodiments of this application. FIG. 2B is a schematic diagram of a structure of a heat dissipation module according to some other embodiments of this application.

In some embodiments, as shown in FIG. 2A, the electronic device 200 includes one heat dissipation module 100. The heat dissipation module 100 includes a first cooling pipeline 10 (a pipeline for inputting a cooling working substance), a second cooling pipeline 20 (a pipeline for outputting the cooling working substance), a first cold plate 30, a second cold plate 40, a heat pipe 50, a first cold plate bracket 60, a second cold plate bracket 70, and a third cooling pipeline 80. The first cold plate bracket 60 may be configured to support the first cold plate 30, and the second cold plate bracket 70 may be configured to support the second cold plate 40. The first cold plate 30 and the second cold plate 40 are connected in series and communicate between the first cooling pipeline 10 and the second cooling pipeline 20. For example, an inlet of the first cold plate 30 communicates with the first cooling pipeline 10, an outlet of the first cold plate 30 communicates with an inlet of the second cold plate 40 through the third cooling pipeline 80, and an outlet of the second cold plate 40 communicates with the second cooling pipeline 20, so that the first cold plate 30 and the second cold plate 40 are connected in series and communicate between the first cooling pipeline 10 and the second cooling pipeline 20 Therefore, the two cold plates connected in series in the heat dissipation module 100 may be used to simultaneously perform heat dissipation for the to-be-heat-dissipated part 300. This can help improve a heat dissipation effect of the heat dissipation module 100.

In addition, the heat pipe 50 is connected to the first cold plate 30 and the second cold plate 40. That is, one end of any heat pipe 50 is in contact with the first cold plate 30, and the other end of the heat pipe 50 is in contact with the second cold plate 40.

In a process of using the heat dissipation module 100, the cooling working substance may sequentially flow into the first cold plate 30 through the first cooling pipeline 10, absorb heat on the first cold plate 30, and be discharged to the third cooling pipeline 80 through the second cooling pipeline 20. Then, because the heat pipe 50 is connected to the first cold plate 30 and the second cold plate 40, some heat on the first cold plate 30 may be absorbed by using a part that is of the heat pipe 50 and that is in contact with the first cold plate 30, and then the some heat may be released to the second cold plate 40 by using a part that is of the heat pipe 50 and that is in contact with the second cold plate 40. In this case, the cooling working substance located in the third cooling pipeline 80 may flow into the second cold plate 40 through the first cooling pipeline 10, and absorb heat on the second cold plate 40, and then the heated cooling working substance is discharged through the second cooling pipeline 20, to implement heat dissipation for the to-be-heat-dissipated part 300.

In some examples, as shown in FIG. 2A, the cooling working substance in the heat dissipation module 100 may first flow to the first cold plate 30, and then flow to the second cold plate 40.

In some examples, the heated cooling working substance in the second cold plate 40 in the heat dissipation module 100 is discharged to an external liquid cooling source through the second cooling pipeline 20. Cooling processing is performed on the cooling working substance by using the liquid cooling source. After the cooling working substance is cooled, the foregoing steps are repeated. That is, the cooling working substance is input into the first cold plate 30 in the heat dissipation module 100 again to form a cycle, so as to implement heat dissipation for the to-be-heat-dissipated part 300.

For example, the first cooling pipeline 10 and the second cooling pipeline 20 may be connected to an external cooling source through a connection structure 210, to provide a cooling working substance for the heat dissipation module 100, and perform cooling processing on the heated cooling working substance. The connection structure 210 may be a heat exchange connector.

In some examples, the connection structure 210 may include a first heat exchange connector 211 and a second heat exchange connector 212. The first heat exchange connector 211 may communicate with the first cooling pipeline 10. A cooling working substance is provided through the first heat exchange connector 211, and then the cooling working substance is input to the first cold plate 30 through the first cooling pipeline 10. The second heat exchange connector 212 may communicate with the second cooling pipeline 20. The second cooling pipeline 20 outputs the heated cooling working substance in the second cold plate 40 to the external cooling source through the second heat exchange connector 212. Cooling processing is performed on the cooling working substance by using the liquid cooling source. After the cooling working substance is cooled, the foregoing steps are repeated.

In some examples, the connection structure 210 may further include a first connection pipe 220 and a second connection pipe 230. Two ends of the first connection pipe 220 respectively communicate with the first heat exchange connector 211 and the first cooling pipeline 10. Two ends of the second connection pipe 230 respectively communicate with the second heat exchange connector 212 and the second cooling pipeline 20.

For example, protective layers may be disposed on outer sides of pipe walls of the first connection pipe 220 and the second connection pipe 230. For example, the protective layer may be a thermal insulation layer, to prevent an ambient temperature from affecting a temperature of the cooling working substance. Alternatively, a corrosion-resistant material may be selected as a material of the protective layer, to protect the first heat exchange connector 211 and the second heat exchange connector 212, and prolong service lives of the first heat exchange connector 211 and the second heat exchange connector 212.

In some other embodiments, as shown in FIG. 2B, the heat dissipation module 100 includes a first cooling pipeline 10 (a pipeline for inputting a cooling working substance), a second cooling pipeline 20 (a pipeline for outputting the cooling working substance), a first cold plate 30, a second cold plate 40, a heat pipe 50, a first cold plate bracket 60, and a second cold plate bracket 70. The first cold plate bracket 60 may be configured to support the first cold plate 30, and the second cold plate bracket 70 may be configured to support the second cold plate 40. The first cooling pipeline 10 includes a first branch pipe 10a, a second branch pipe 10b, and a first main pipe 10c. The second cooling pipeline 20 includes a third branch pipe 20a, a fourth branch pipe 20b, and a second main pipe 20c.

Different from FIG. 2A, the first cold plate 30 and the second cold plate 40 are connected in parallel and communicate between the first cooling pipeline 10 and the second cooling pipeline 20.

For example, one end of the first branch pipe 10a and one end of the second branch pipe 10b communicate with the first main pipe 10c. One end of the third branch pipe 20a and one end of the fourth branch pipe 20b communicate with the second main pipe 20c. An inlet of the first cold plate 30 communicates with the other end of the first branch pipe 10a, and an outlet of the first cold plate 30 communicates with the other end of the third branch pipe 20a. In addition, an inlet of the second cold plate 40 communicates with the other end of the second branch pipe 10b, and an outlet of the second cold plate 40 communicates with the other end of the fourth branch pipe 20b. Therefore, the two cold plates connected in parallel in the heat dissipation module 100 may be used to simultaneously perform heat dissipation for the to-be-heat-dissipated part 300. This can help improve a heat dissipation effect of the heat dissipation module 100.

In addition, the heat pipe 50 is connected to the first cold plate 30 and the second cold plate 40. That is, one end of any heat pipe 50 is in contact with the first cold plate 30, and the other end of the heat pipe 50 is in contact with the second cold plate 40.

In a process of using the heat dissipation module 100, the cooling working substance may separately flow to the first branch pipe 10a and the second branch pipe 10b through the first main pipe 10c in the first cooling pipeline 10. Further, the cooling working substance may flow into the first cold plate 30 through the first branch pipe 10a, absorb heat on the first cold plate 30, and then be discharged to the outside of the heat dissipation module 100, that is, discharged to the second main pipe 20c, through the third branch pipe 20a in the second cooling pipeline 20, and finally the heated refrigerant is discharged through the second main pipe 20c. Then, because the heat pipe 50 is connected to the first cold plate 30 and the second cold plate 40, some heat on the first cold plate 30 may be absorbed by using a part that is of the heat pipe 50 and that is in contact with the first cold plate 30, and then the some heat may be released to the second cold plate 40 by using a part that is of the heat pipe 50 and that is in contact with the second cold plate 40. In addition, the cooling working substance may flow into the second cold plate 40 through the second branch pipe 10b in the first cooling pipeline 10, absorb heat on the second cold plate 40, and then be discharged to the outside of the heat dissipation module 100, that is, discharged to the second main pipe 20c, through the fourth branch pipe 20b in the second cooling pipeline 20, and finally the heated refrigerant is discharged through the second main pipe 20c. In conclusion, the cooling working substance flowing through the first cold plate 30 and the second cold plate 40 may be discharged to the heat dissipation module 100 through the second main pipe 20c after being heated, to implement heat dissipation for the to-be-heat-dissipated part 300.

In some examples, as shown in FIG. 2B, the cooling working substance simultaneously flows to the first cold plate 30 and the second cold plate 40.

For example, the heat dissipation module 100 may discharge the heated cooling working substance in the heat dissipation module 100 to an external liquid cooling source through the second main pipe 20c. Cooling processing is performed on the cooling working substance by using the liquid cooling source. After the cooling working substance is cooled, the foregoing steps are repeated. That is, the cooling working substance is input into the heat dissipation module 100 again through the first main pipe 10c to form a cycle, so as to implement heat dissipation for the to-be-heat-dissipated part 300.

For example, the first main pipe 10c in the first cooling pipeline 10 and the second main pipe 20c in the second cooling pipeline 20 may be connected to an external cooling source through a connection structure 210, to provide a cooling working substance for the heat dissipation module 100, and perform cooling processing on the heated cooling working substance. A specific structure of the connection structure 210 may be the same as the connection structure 210 shown in FIG. 2A. That is, for the connection structure 210 provided in this embodiment, refer to the foregoing descriptions of the connection structure 210. Details are not described herein again.

In some examples, as shown in FIG. 2A and FIG. 2B, the first cold plate bracket 60 may be further configured to support one end of the heat pipe 50, so that the one end of the heat pipe 50 is in contact with the first cold plate 30.

In some examples, as shown in FIG. 2A and FIG. 2B, the second cold plate bracket 70 may be further configured to support the other end of the heat pipe 50, so that the other end of the heat pipe 50 is in contact with the second cold plate 40.

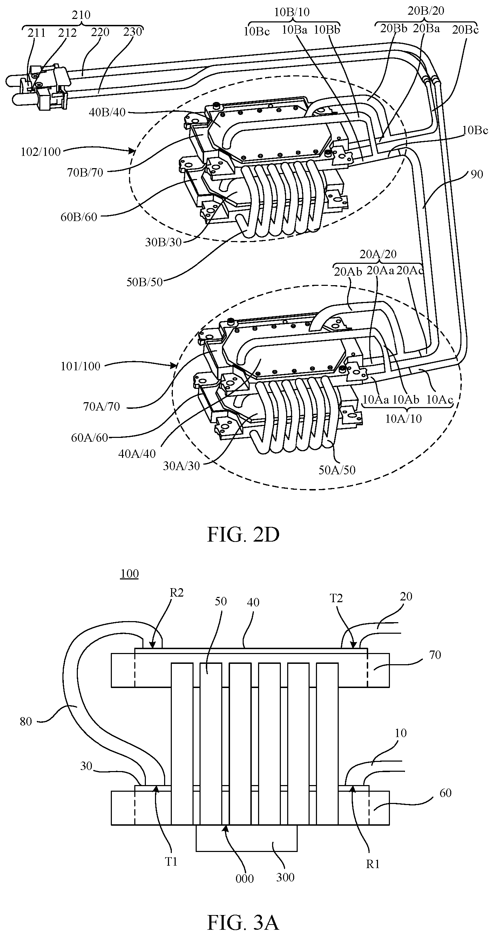

In the foregoing descriptions, with reference to FIG. 2A and FIG. 2B, an example in which the electronic device 200 includes one heat dissipation module 100 is used for illustration. With reference to FIG. 2C and FIG. 2D, an example in which the electronic device 200 includes two heat dissipation modules 100 is used below for illustration.

FIG. 2C is a schematic diagram of a structure of two heat dissipation modules connected in series according to some embodiments of this application. FIG. 2D is a schematic diagram of a structure of two heat dissipation modules connected in series according to some other embodiments of this application.

In some embodiments, as shown in FIG. 2C and FIG. 2D, the two heat dissipation modules 100 are a first heat dissipation module 101 and a second heat dissipation module 102. The electronic device 200 further includes a fourth cooling pipeline 90. The first heat dissipation module 101 and the second heat dissipation module 102 may be connected in series. For example, FIG. 2C is used as an example. In two adjacent heat dissipation modules 100, an inlet of a first cold plate 30A in a first heat dissipation module 101 communicates with a first cooling pipeline 10A, and an outlet of a second cold plate 40B in a second heat dissipation module 102 communicates with a second cooling pipeline 20B. In addition, an outlet of a second cold plate 20A in the first heat dissipation module 101 may communicate with an inlet of a first cold plate 10B in the second heat dissipation module 102 through the fourth cooling pipeline 90, to connect the two adjacent heat dissipation modules 100 in series.

In such an arrangement, a cooling working substance flows through the first cooling pipeline 10A and is input into the first heat dissipation module 101, and absorbs heat on the to-be-heat-dissipated part 300 (as shown in FIG. 1), and the cooling working substance is heated. The heated cooling working substance is discharged to the second heat dissipation module 102 through the fourth cooling pipeline 90. A cooling working substance in the heat dissipation module 102 absorbs heat on the to-be-heat-dissipated part 300, and the cooling working substance is heated and then discharged to a next heat dissipation module. When the second heat dissipation module 102 is a last heat dissipation module, the heated cooling working substance may be discharged to the outside of the second heat dissipation module 102 through the second cooling pipeline 20B, to implement heat dissipation for the to-be-heat-dissipated part 300. In such an arrangement, a plurality of heat dissipation modules 100 may be used for joint heat dissipation. This can help improve a heat dissipation effect of the heat dissipation module 100.

For example, the heated cooling working substance in the last heat dissipation module 100 in the heat dissipation modules 100 is discharged to an external liquid cooling source through the second cooling pipeline 20B. Cooling processing is performed on the cooling working substance by using the liquid cooling source. After the cooling working substance is cooled, the foregoing steps are repeated. That is, the cooling working substance is input into the first heat dissipation module 101 again through the first cooling pipeline 10A to form a cycle, so as to implement heat dissipation for the to-be-heat-dissipated part 300.

However, a connection relationship between the plurality of heat dissipation modules 100 is not limited in this disclosure. It may be understood that in some other embodiments, it may be set that a plurality of heat dissipation modules 100 are disposed in parallel.

In some embodiments, as shown in FIG. 2C, the electronic device 200 includes two heat dissipation modules 100, and the two heat dissipation modules 100 are a first heat dissipation module 101 and a second heat dissipation module 102. The electronic device 200 further includes a fourth cooling pipeline 90. The first heat dissipation module 100 includes a first cooling pipeline 10A, a second cooling pipeline 20A, a first cold plate 30A, a second cold plate 40A, a heat pipe 50A, a first cold plate bracket 60A, a second cold plate bracket 70A, and a third cooling pipeline 80A. The first cold plate bracket 60A is configured to support the first cold plate 60A, and the second cold plate bracket 70A is configured to support the second cold plate 40A. The second heat dissipation module 102 includes a first cooling pipeline 10B, a second cooling pipeline 20B, a first cold plate 30B, a second cold plate 40B, a heat pipe 50B, a first cold plate bracket 60B, a second cold plate bracket 70B, and a third cooling pipeline 80B. The first cold plate bracket 60B is configured to support the first cold plate 60B, and the second cold plate bracket 70B is configured to support the second cold plate 40B.

The first heat dissipation module 101 is used as an example, and both the first cold plate 30A and the second cold plate 40A are connected in series and communicate between the first cooling pipeline 10A and the second cooling pipeline 20A. For example, an inlet of the first cold plate 30A communicates with the first cooling pipeline 10A. An outlet of the second cold plate 40A communicates with the second cooling pipeline 20A. In addition, an outlet of the first cold plate 30A communicates with an inlet of the second cold plate 40A through the third cooling pipeline 80. Therefore, the first cold plate 30 and the second cold plate 40 are connected in series. Therefore, the two cold plates connected in series in the heat dissipation module 100 may be used to simultaneously perform heat dissipation for the to-be-heat-dissipated part 300. This can help improve a heat dissipation effect of the heat dissipation module 100.

In addition, any heat pipe 50A is connected to the first cold plate 30A and the second cold plate 40A. For example, one end of the any heat pipe 50A is in contact with a contact surface of the first cold plate 30A, and the other end of the heat pipe 50A is in contact with a side that is of the second cold plate 40A and that is close to the first cold plate 30A.

In addition, the second cold plate 40A in the first heat dissipation module 101 communicates with the first cold plate 30B in the second heat dissipation module 102, to connect the first heat dissipation module 101 and the second heat dissipation module 102 in series. For example, the second cooling pipeline 20A connected to the second cold plate 40A in the first heat dissipation module 101 may communicate, through the fourth cooling pipeline 90, with the first cooling pipeline 10B connected to the first cold plate 30B in the second heat dissipation module 102.

For a specific structure of the second heat dissipation module 102, refer to the foregoing descriptions because a structure of the second heat dissipation module 102 is the same as a structure of the first heat dissipation module 101. Details are not described herein again.

In a process of using the first heat dissipation module 101 and the second heat dissipation module 102, the cooling working substance may flow into the first cold plate 30A in the first heat dissipation module 101 through the first cooling pipeline 10A, absorb heat on the first cold plate 30A, and then be discharged to the third cooling pipeline 80A. Then, because one end of any heat pipe 50A is in contact with the first cold plate 30A, some heat on the first cold plate 30A may be absorbed by using a part that is of the heat pipe 50A and that is in contact with the first cold plate 30A, and then the some heat may be released to the second cold plate 40A by using a part that is of the heat pipe 50A and that is in contact with the second cold plate 40A. In this case, the cooling working substance located in the third cooling pipeline 80A may flow into the second cold plate 40A, absorb heat on the second cold plate 40A, and then be discharged to the fourth cooling pipeline 90 through the second cooling pipeline 20A.

In this case, the cooling working substance located in the fourth cooling pipeline 90 may flow into the first cold plate 30B in the second heat dissipation module 102 through the first cooling pipeline 10B in the second heat dissipation module 102, absorb heat on the first cold plate 30B, and then be discharged to the third cooling pipeline 80. Then, some heat on the first cold plate 30B may be absorbed by using a part that is of the heat pipe 50B and that is in contact with the first cold plate 30B, and then the some heat may be released to the second cold plate 40B by using a part that is of the heat pipe 50B and that is in contact with the second cold plate 40B. In this case, the cooling working substance located in the third cooling pipeline 80B may flow into the second cold plate 40B, absorb heat on the second cold plate 40B, and then be discharged to the second cooling pipeline 20B. Finally, the heated cooling working substance is discharged through the second cooling pipeline 20B, to implement heat dissipation for the to-be-heat-dissipated part 300

In some examples, as shown in FIG. 2C, the cooling working substance in the heat dissipation module 100 may first flow to the first cold plate 30, and then flow to the second cold plate 40.

For example, the heated cooling working substance in the second cold plate 40B in the heat dissipation module 100 is discharged to an external liquid cooling source through the second cooling pipeline 20B. Cooling processing is performed on the cooling working substance by using the liquid cooling source. After the cooling working substance is cooled, the foregoing steps are repeated. That is, the cooling working substance is input into the first cold plate 30A in the heat dissipation module 100 again to form a cycle, so as to implement heat dissipation for the to-be-heat-dissipated part 300.

For example, the first cooling pipeline 10A and the second cooling pipeline 20B may be connected to an external cooling source through a connection structure 210, to provide a cooling working substance for the heat dissipation module 100, and perform cooling processing on the heated cooling working substance. A specific structure of the connection structure 210 may be the same as the connection structure 210 shown in FIG. 2A. That is, for the connection structure 210 provided in this embodiment, refer to the foregoing descriptions of the connection structure 210. Details are not described herein again.

In some embodiments, as shown in FIG. 2D, the electronic device 200 includes two heat dissipation modules 100, and the two heat dissipation modules 100 are a first heat dissipation module 101 and a second heat dissipation module 102. The electronic device 200 further includes a fourth cooling pipeline 90.

The first heat dissipation module 101 includes a first cooling pipeline 10A, a second cooling pipeline 20A, a first cold plate 30A, a second cold plate 40A, a heat pipe 50A, a first cold plate bracket 60A, a second cold plate bracket 70A, and a third cooling pipeline 80A. The first cold plate bracket 60A is configured to support the first cold plate 30A, and the second cold plate bracket 70A is configured to support the second cold plate 40A. The first cooling pipeline 10A includes a first branch pipe 10Aa, a second branch pipe 10Ab, and a first main pipe 10Ac. One end of the first branch pipe 10Aa and one end of the second branch pipe 10Ab communicate with the first main pipe 10Ac. The second cooling pipeline 20A includes a third branch pipe 20Aa, a fourth branch pipe 20Ab, and a second main pipe 20Ac. One end of the third branch pipe 20Aa and one end of the fourth branch pipe 20Ab communicate with the second main pipe 20Ac.

The second heat dissipation module 102 includes a first cooling pipeline 10B, a second cooling pipeline 20B, a first cold plate 30B, a second cold plate 40B, a heat pipe 50B, a first cold plate bracket 60B, a second cold plate bracket 70B, and a third cooling pipeline 80B. The first cold plate bracket 60B is configured to support the first cold plate 30B, and the second cold plate bracket 70B is configured to support the second cold plate 40B. The first cooling pipeline 10B includes a first branch pipe 10Ba, a second branch pipe 10Bb, and a first main pipe 10Bc. One end of the first branch pipe 10Ba and one end of the second branch pipe 10Bb communicate with the first main pipe 10Bc. The second cooling pipeline 20B includes a third branch pipe 20Ba, a fourth branch pipe 20Bb, and a second main pipe 10Bc. One end of the third branch pipe 20Ba and one end of the fourth branch pipe 20Bb communicate with the second main pipe 10Bc.

Different from FIG. 2C, the first heat dissipation module 101 is used as an example, and both the first cold plate 30A and the second cold plate 40A are connected in parallel and communicate between the first cooling pipeline 10A and the second cooling pipeline 20A. For example, an inlet of the first cold plate 30A communicates with the first branch pipe 10Aa in the first cooling pipeline 10A, and an outlet of the first cold plate 30 communicates with the third branch pipe 20Aa in the second cooling pipeline 20A. In addition, an inlet of the second cold plate 40A communicates with the second branch pipe 10Ab in the first cooling pipeline 10A, and the second cold plate 40A communicates with the fourth branch pipe 20Ab in the second cooling pipeline 20A. The first branch pipe 10Aa and the second branch pipe 10Ab communicate with the first main pipe 10Ac, and the third branch pipe 20Aa and the fourth branch pipe 20Ab communicate with the second branch pipe 10Bc. Therefore, the first cold plate 30A and the second cold plate 40A are connected in parallel and communicate between the first cooling pipeline 10A and the second cooling pipeline 20A. Therefore, the two cold plates (the first cold plate 30A and the second cold plate 40A) connected in parallel in the first heat dissipation module 101 may be used to simultaneously perform heat dissipation for the to-be-heat-dissipated part 300. This can help improve a heat dissipation effect of the first heat dissipation module 101.

In addition, any heat pipe 50A is connected to the first cold plate 30A and the second cold plate 40A. For example, one end of the any heat pipe 50A is in contact with a contact surface of the first cold plate 30A, and the other end of the heat pipe 50A is in contact with a side that is of the second cold plate 40A and that is close to the first cold plate 30A.

Because a structure of the second heat dissipation module 102 is the same as a structure of the first heat dissipation module 101, reference may be made to the foregoing descriptions. Details are not described herein again.

In a process of using the first heat dissipation module 101 and the second heat dissipation module 102, the cooling working substance may flow into the first cold plate 30A in the first heat dissipation module 101 through the first branch pipe 10Aa in the first cooling pipeline 10A, absorb heat on the first cold plate 30A, and then be discharged to the fourth cooling pipeline 90 through the third branch pipe 20Aa in the second cooling pipeline 20A. Then, because one end of any heat pipe 50A is in contact with the first cold plate 30A, some heat on the first cold plate 30A may be absorbed by using a part that is of the heat pipe 50A and that is in contact with the first cold plate 30A, and then the some heat may be released to the second cold plate 40A by using a part that is of the heat pipe 50A and that is in contact with the second cold plate 40A. In this case, the cooling working substance may flow into the second cold plate 40A in the first heat dissipation module 101 through the second branch pipe 10Ab in the first cooling pipeline 10A, absorb heat on the second cold plate 40A, and then be discharged to the fourth cooling pipeline 90 through the fourth branch pipe 20Ab in the second cooling pipeline 20A.

In this case, the cooling working substance located in the fourth cooling pipeline 90 may flow into the first cold plate 30B in the second heat dissipation module 102 through the first branch pipe 10Ba in the first cooling pipeline 10B, absorb heat on the first cold plate 30B, and then be discharged through the third branch pipe 20Ba in the second cooling pipeline 20B. Then, some heat on the first cold plate 30B may be absorbed by using a part that is of the heat pipe 50B and that is in contact with the first cold plate 30B, and then the some heat may be released to the second cold plate 40B in the second heat dissipation module 102 by using a part that is of the heat pipe 50B and that is in contact with the second cold plate 40B. In this case, the cooling working substance may flow into the second cold plate 40B in the second heat dissipation module 102 through the second branch pipe 10Bb in the first cooling pipeline 10B, absorb heat on the second cold plate 40B, and then be discharged through the fourth branch pipe 20Bb in the second cooling pipeline 20B. That is, the cooling working substance flowing through the first cold plate 30B and the second cold plate 40B in the second heat dissipation module 102 (a last heat dissipation module) is discharged to the outside of the second heat dissipation module 102 after being heated, to implement heat dissipation for the to-be-heat-dissipated part 300.

In some examples, as shown in FIG. 2D, the cooling working substance in the heat dissipation module 100 may simultaneously flow to the first cold plate 30 and the second cold plate 40.

For example, the heat dissipation module 100 may discharge the heated cooling working substance in the heat dissipation module 100 to an external liquid cooling source through the second main pipe 20Bc. Cooling processing is performed on the cooling working substance by using the liquid cooling source. After the cooling working substance is cooled, the foregoing steps are repeated. That is, the cooling working substance is input into the heat dissipation module 100 again through the first main pipe 10Ac to form a cycle, so as to implement heat dissipation for the to-be-heat-dissipated part 300.

For example, the first main pipe 10Ac in the first cooling pipeline 10A and the second main pipe 20Bc in the second cooling pipeline 20B may be connected to an external cooling source through a connection structure 210, to provide a cooling working substance for the heat dissipation module 100, and perform cooling processing on the heated cooling working substance. A specific structure of the connection structure 210 may be the same as the connection structure 210 shown in FIG. 2A. That is, for the connection structure 210 provided in this embodiment, refer to the foregoing descriptions of the connection structure 210. Details are not described herein again.

The foregoing describes the electronic device 200 and the quantity of heat dissipation modules 100 in the electronic device with reference to some accompanying drawings. The following describes in detail a structure of the heat dissipation module 100 in the electronic device 200 with reference to some other accompanying drawings.

In some examples, a structure of the first cold plate bracket 60B may be the same as a structure of the first cold plate bracket 60A, and reference may be made to the foregoing descriptions of the structure of the first cold plate bracket 60A. In addition, a structure of the second cold plate bracket 70B may be the same as a structure of the second cold plate bracket 70A, and reference may be made to the foregoing descriptions of the structure of the second cold plate bracket 70A. Details are not described herein again.

In some examples, as shown in FIG. 2C and FIG. 2D, the first cold plate bracket 60A may be further configured to support one end of the heat pipe 50A, so that the one end of the heat pipe 50A is in contact with the first cold plate 30A.

In some examples, as shown in FIG. 2C and FIG. 2D, the second cold plate bracket 70A may be further configured to support the other end of the heat pipe 50A, so that the other end of the heat pipe 50A is in contact with the second cold plate 40A.

FIG. 3A is a plan view of a structure shown in a dashed line box in FIG. 2A from a first perspective V.

The heat dissipation module 100 includes a first cooling pipeline 10, a second cooling pipeline 20, a first cold plate 30, a second cold plate 40, at least one heat pipe 50, a first cold plate bracket 60, and a second cold plate bracket 70. The first cooling pipeline 10 is configured to input a cooling working substance, and the second cooling pipeline 20 is configured to output the cooling working substance. The first cold plate bracket 60 may be configured to support the first cold plate 30, and the second cold plate bracket 70 may be configured to support the second cold plate 40.

The first cold plate 30 communicates with the first cooling pipeline 10 and the second cooling pipeline 20, and a contact surface 000 of the first cold plate 30 is in contact with a to-be-heat-dissipated part 300, and is configured to absorb heat on the to-be-heat-dissipated part 300.

When the heat dissipation module 100 is used, because the contact surface 000 of the first cold plate 30 is in contact with the to-be-heat-dissipated part 300, the heat on the to-be-heat-dissipated part 300 may be transferred to the first cold plate 30. For example, the heat on the to-be-heat-dissipated part 300 may be transferred to the first cold plate 30 through the contact surface of the first cold plate 30. Therefore, the first cold plate 30 may be used to absorb the heat on the to-be-heat-dissipated part 300. In addition, the first cold plate 30 communicates between the first cooling pipeline 10 and the second cooling pipeline 20. Therefore, in a use process, the cooling working substance may flow into the first cold plate 30 through the first cooling pipeline 10, absorb heat on the first cold plate 30, and then be discharged to the outside of the first cold plate 30 through the second cooling pipeline 20. That is, as the cooling working substance flows, heat generated by the to-be-heat-dissipated part 300 may be released through the first cold plate 30 and the cooling working substance flowing through the first cold plate 30, to implement heat dissipation for the to-be-heat-dissipated part 300.

As shown in FIG. 3A, the second cold plate 40 is disposed at an interval from the first cold plate 30, and the second cold plate 40 is connected to the first cold plate 30 through at least one heat pipe 50. Heat on the first cold plate 30 may be absorbed by using a part that is of the heat pipe 50 and that is in contact with the first cold plate 30 for transfer, and then the absorbed some heat may be released to the second cold plate 40 by using a part that is of the heat pipe 50 and that is in contact with the second cold plate 40.

Therefore, the second cold plate 40 and the heat pipe 50 are disposed, to further reduce heat on the first cold plate 30, so as to implement better heat dissipation for the to-be-heat-dissipated part 300. Therefore, the heat pipe 50 may be used, so that the second cold plate 40 can share heat that is on the to-be-heat-dissipated part 300 and that is absorbed by the first cold plate 30. Therefore, this helps reduce thermal resistance (that is, a ratio of a temperature difference between a cooling working substance inlet and a cooling working substance outlet of the first cold plate 30 to power of the to-be-heat-dissipated part 300) of the first cold plate 30, and improves a heat dissipation effect on the to-be-heat-dissipated part 300.

In addition, the second cold plate 40 further communicates with the first cooling pipeline 10 and the second cooling pipeline 20. Therefore, in a use process, the cooling working substance may further flow into the second cold plate 40 through the first cooling pipeline 10, absorb heat on the second cold plate 40, and then be discharged to the outside of the second cold plate 40 through the second cooling pipeline 20. That is, as the cooling working substance flows, the heat on the second cold plate 40 may be released through the cooling working substance flowing through the second cold plate 40, to implement heat dissipation for the second cold plate 40. In this case, a heat dissipation effect on the first cold plate 30 and the to-be-heat-dissipated part 300 may also be improved. Therefore, this helps further reduce the thermal resistance of the first cold plate 30, and improves the heat dissipation effect on the to-be-heat-dissipated part 300.

Based on the foregoing descriptions, compared with a case in which only the first cold plate 30 is used to perform heat dissipation for the to-be-heat-dissipated part 300, the heat dissipation module 100 provided in this embodiment of this application may distribute some heat on the to-be-heat-dissipated part 300 to the second cold plate 40. That is, the first cold plate 30 and the second cold plate 40 may be simultaneously used to perform heat dissipation for the to-be-heat-dissipated part 300, to improve a heat dissipation effect of the heat dissipation module 100.

For example, the heated cooling working substance in the heat dissipation module 100 is discharged to an external liquid cooling source through the second cooling pipeline 20. Cooling processing is performed on the cooling working substance by using the liquid cooling source. After the cooling working substance is cooled, the foregoing steps are repeated. That is, the cooling working substance flows into the heat dissipation module 100 again through the first cooling pipeline 10 to form a cycle, so as to implement heat dissipation for the to-be-heat-dissipated part 300.

In some examples, a parameter of the heat pipe 50 may be adjusted, to evenly distribute, by using the heat pipe 50, heat that is on a heat source and that is absorbed by the first cold plate 30 and the second cold plate 40, so that the first cold plate 30 and the second cold plate 40 have relatively even heat dissipation capabilities. This improves uniformity of heat dissipation effects of the heat dissipation module 100 in different regions, and improves performance of the heat dissipation module 100.

For example, a quantity, aperture lengths, internal structures, and the like of heat pipes 50 may be adjusted, to evenly distribute, by using the heat pipe 50, the heat that is on the heat source and that is absorbed by the first cold plate 30 and the second cold plate 40.

In some examples, the cooling working substance in the heat dissipation module 100 may be any one or more of water, 25% propylene glycol, or 25% ethylene glycol. It may be understood that the cooling working substance in the heat dissipation module 100 may be some other cooling working substances that can absorb heat. This is not limited in this embodiment of this application.

In FIG. 3A, an example in which the heat dissipation module 100 includes six heat pipes 50 is used for illustration. It may be understood that in some other embodiments, a quantity of heat pipes 50 may be set to 1, 2, 3, or more.

The foregoing generally describes the structure of the heat dissipation module 100 with reference to some accompanying drawings. The following continues to describe a connection manner of the first cold plate 30 and the second cold plate 40 in the heat dissipation module 100 with reference to the accompanying drawings.

In some embodiments, as shown in FIG. 3A, the heat dissipation module 100 further includes a third cooling pipeline 80. The first cold plate 30 includes a first inlet R1 and a first outlet T1, and the second cold plate 40 includes a second inlet R2 and a second outlet T2. The first inlet R1 communicates with the first cooling pipeline 10, and the second outlet T2 communicates with the second cooling pipeline 20. One end of the third cooling pipeline 80 communicates with the first outlet T1, and the other end of the third cooling pipeline 80 communicates with the second inlet R2.

In such an arrangement, the second cold plate 40 and the first cold plate 30 are connected in series between the first cooling pipeline 10 and the second cooling pipeline 20.

In a process of using the heat dissipation module 100, the cooling working substance flowing through the first cooling pipeline 10 flows into the first cold plate 30 through the first inlet R1, and absorbs heat on the first cold plate 30, and then the heated cooling working substance in the first cold plate 30 flows to the second cooling pipeline 20 through the first outlet T1, and then is discharged to the third cooling pipeline 80 through the second cooling pipeline 20.

Then, some heat on the first cold plate 30 may be absorbed by using a part that is of the heat pipe 50 and that is in contact with the first cold plate 30, and then the some heat may be released to the second cold plate 40 by using a part that is of the heat pipe 50 and that is in contact with the second cold plate 40. In this case, the cooling working substance located in the third cooling pipeline 80 may flow through the first cooling pipeline 10, flow into the second cold plate 40 through the second inlet R2, and absorb heat on the second cold plate 40, and then the heated cooling working substance in the second cold plate 40 flows to the second cooling pipeline 20 through the second outlet T2, and then is discharged to the outside of the second cold plate 40, that is, is discharged to the outside of the heat dissipation module 100, through the second cooling pipeline 20, to implement heat dissipation for the to-be-heat-dissipated part 300.

It may be understood that the heat dissipation module 100 provided in this embodiment of this application distributes the heat on the to-be-heat-dissipated part 300 to the first cold plate 30 and the second cold plate 40 by using the heat pipe 50 for simultaneous heat dissipation. Because the first cold plate 30 and the second cold plate 40 are connected in series, when there is consistent heat that needs to be dissipated, for example, when there is consistent heat on the to-be-heat-dissipated part 300, compared with using only one cold plate for heat dissipation, using the first cold plate 30 and the second cold plate 40 for simultaneous heat dissipation can distribute the heat on the first cold plate 30. Therefore, in a case of a same heat dissipation requirement, compared with one cold plate, two cold plates can decrease a flow rate. That is, a low flow rate can meet a heat dissipation requirement. In addition, when the cooling working substance flows in the first cold plate, a pressure drop is caused due to an energy loss. This energy loss is caused due to collision and momentum exchange between mass points (the mass point is a point with mass but without a volume or shape) of the cooling working substance when the cooling working substance flows to overcome friction force in the first cold plate and overcome turbulence, and is reflected as a pressure difference generated before and after the cooling working substance flows. It may be learned that the pressure drop in the first cold plate 30 may be decreased with a flow rate in the first cold plate 30. This helps improve a heat dissipation effect of the first cold plate 30, that is, this helps improve the heat dissipation effect of the heat dissipation module 100. In addition, a working status of the second cold plate 40 is similar to that of the first cold plate 30, that is, a flow rate of the cooling working substance in the second cold plate 40 is also less than a flow rate and a pressure drop in a cold plate when only one cold plate is disposed, to improve the heat dissipation effect of the heat dissipation module 100.

It may be learned that the heat dissipation module 100 includes the first cold plate 30 and the second cold plate 40 that are connected through the heat pipe 50, and when the first cold plate 30 and the second cold plate 40 are connected in series, this can help improve the heat dissipation effect of the heat dissipation module 100.

In some examples, when there is consistent heat that needs to be dissipated, for example, when there is consistent heat on the to-be-heat-dissipated part 300, compared with using one cold plate to perform heat dissipation for the to-be-heat-dissipated part 300, disposing two cold plates (the first cold plate 30 and the second cold plate 40) in series for joint heat dissipation can decrease a flow rate of the cooling working substance in the heat dissipation module 100 by approximately 25% and decrease a pressure drop by approximately 7%.

It should be noted that in some examples, due to a specific uncontrollable error (for example, a manufacturing process error, device precision, or a measurement error), a flow rate decrease error of the cooling working substance may be within a range of 25%×±5%, and a pressure drop decrease error may be within a range of 7%×±5%.

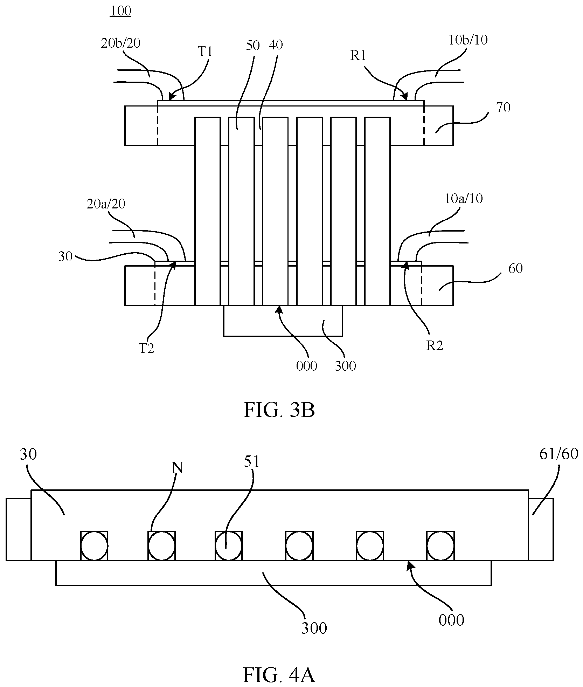

FIG. 3B is a plan view of a structure shown in a dashed line box in FIG. 2B from a first perspective V.

In some embodiments, as shown in FIG. 3B, and with reference to FIG. 2B, the heat dissipation module 100 includes a first cooling pipeline 10, a second cooling pipeline 20, a first cold plate 30, a second cold plate 40, at least one heat pipe 50, a first cold plate bracket 60, and a second cold plate bracket 70. The first cooling pipeline 10 includes a first branch pipe 10a, a second branch pipe 10b, and a first main pipe 10c. In addition, the first cold plate 30 includes a first inlet R1 and a first outlet T1, and the second cold plate 40 includes a second inlet R2 and a second outlet T2.

In this case, the first inlet R1 of the first cold plate 30 communicates with the first branch pipe 10a, and the first outlet T1 of the first cold plate 30 communicates with a third branch pipe 20a. In addition, the second inlet of the second cold plate 40 communicates with the third branch pipe 20a, and the second outlet of the second cold plate 40 communicates with a fourth branch pipe 20b. Furthermore, one end of the first branch pipe 10a and one end of the second branch pipe 10b communicate with the first main pipe 10c. The second cooling pipeline 20 includes the third branch pipe 20a, the fourth branch pipe 20b, and a second main pipe 20c. One end of the third branch pipe 20a and one end of the fourth branch pipe 20b communicate with the second main pipe 20c.

In such an arrangement, the second cold plate 40 and the first cold plate 30 are connected in parallel between the first cooling pipeline 10 and the second cooling pipeline 20.

In a process of using the heat dissipation module 100, a cooling working substance flowing through the first main pipe 10c in the first cooling pipeline 10 may simultaneously separately flow to different cold plates through the first branch pipe 10a and the second branch pipe 10b. For example, the cooling working substance flowing to the first branch pipe 10a through the first main pipe 10c in the first cooling pipeline 10 may flow into the first cold plate 30 through the first inlet R1, and absorb heat on the first cold plate 30, and then the heated cooling working substance in the first cold plate 30 is discharged to the outside of the first cold plate 30 through the first outlet T1, that is, the heated cooling working substance may flow to the second main pipe 20c through the third branch pipe 20a in the second cooling pipeline 20, and then be discharged to the outside of the heat dissipation module 100 through the second main pipe 20c in the second cooling pipeline 20. Then, some heat on the first cold plate 30 may be absorbed by using a part that is of the heat pipe 50 and that is in contact with the first cold plate 30, and then the some heat may be released to the second cold plate 40 by using a part that is of the heat pipe 50 and that is in contact with the second cold plate 40.

In this case, the cooling working substance flowing to the second branch pipe 10b through the first main pipe 10c in the first cooling pipeline 10 may flow into the second cold plate 40 through the second inlet R2, and absorb heat on the second cold plate 40, and then the heated cooling working substance in the second cold plate 40 is discharged to the outside of the second cold plate 40 through the second outlet T2, that is, the heated cooling working substance may flow to the second main pipe 20c through the fourth branch pipe 20b in the second cooling pipeline 20, and then be discharged to the outside of the heat dissipation module 100 through the second main pipe 20c in the second cooling pipeline 20. That is, the cooling working substance flowing through the first cold plate 30 and the second cold plate 40 may be discharged through the second main pipe 20c after being heated, to implement heat dissipation for the to-be-heat-dissipated part 300.

It may be understood that the heat dissipation module 100 provided in this embodiment of this application distributes the heat on the to-be-heat-dissipated part 300 to the first cold plate 30 and the second cold plate 40 by using the heat pipe 50 for simultaneous heat dissipation. Because the first cold plate 30 and the second cold plate 40 are connected in parallel, a flow rate of a cooling working substance in originally one cold plate is distributed to the first cold plate 30 and the second cold plate 40. Therefore, when there is a same flow rate of the cooling working substance flowing through the heat dissipation module 100, the flow rate of the cooling working substance may be shared by using the two cold plates, to decrease a flow rate of the cooling working substance flowing through the first cold plate 30. In addition, a pressure drop in the first cold plate 30 may also be decreased. This helps improve a heat dissipation effect of the first cold plate 30, that is, this helps improve the heat dissipation effect of the heat dissipation module 100. In addition, a working status of the second cold plate 40 is similar to that of the first cold plate 30, that is, a flow rate of the cooling working substance in the second cold plate 40 is also less than a flow rate and a pressure drop in a cold plate when only one cold plate is disposed, to improve the heat dissipation effect of the heat dissipation module 100.

It may be learned that the heat dissipation module 100 includes the first cold plate 30 and the second cold plate 40 that are connected through the heat pipe 50, and when the first cold plate 30 and the second cold plate 40 are connected in parallel, this can help improve the heat dissipation effect of the heat dissipation module 100.

In some examples, when there is a same flow rate of the cooling working substance flowing through the heat dissipation module 100, compared with using one cold plate to perform heat dissipation for the to-be-heat-dissipated part 300, disposing two cold plates (the first cold plate 30 and the second cold plate 40) in parallel for joint heat dissipation can decrease a pressure drop in the heat dissipation module 100 by approximately 70% and relatively decrease the to-be-heat-dissipated part 300 by approximately 3°C.

It should be noted that in some examples, due to a specific uncontrollable error (for example, a manufacturing process error, device precision, or a measurement error), a pressure drop decrease error may be within a range of 70%×±5%, and a temperature decrease error may be within a range of 3°C×±5%.

A connection manner of the first cold plate 30 and the second cold plate 40 in the heat dissipation module 100 is not limited in this embodiment of this disclosure, and may be set based on an actual requirement.

In some examples, as shown in FIG. 3A and FIG. 3B, the first cold plate bracket 60 may be further configured to support one end of the heat pipe 50, so that the one end of the heat pipe 50 is in contact with the first cold plate 30.

In some examples, as shown in FIG. 3A and FIG. 3B, the second cold plate bracket 70 may be further configured to support the other end of the heat pipe 50, so that the other end of the heat pipe 50 is in contact with the second cold plate 40.

In some embodiments, as shown in FIG. 3A and FIG. 3B, a contact surface 000 of the first cold plate 30 in the heat dissipation module 100 is in contact with the to-be-heat-dissipated part 300. The second cold plate 40 may be located on a side that is of the first cold plate and that faces away from the contact surface 000.

Such an arrangement helps reduce space occupation in a direction parallel to the contact surface, and can further ensure that the heat on the second cold plate 40 is not prone to affect the to-be-heat-dissipated part 300.

It may be understood that the foregoing structure is applicable to the heat dissipation module 100, shown in FIG. 3A, in which the first cold plate 30 and the second cold plate 40 are connected in series. In addition, the foregoing structure is also applicable to the heat dissipation module 100, shown in FIG. 3B, in which the first cold plate 30 and the second cold plate 40 are connected in parallel. This is not limited in this embodiment of this disclosure.

The foregoing describes the connection manner of the first cold plate 30 and the second cold plate 40 in the heat dissipation module 100 and a position relationship between the first cold plate 30 and the second cold plate 40 with reference to some accompanying drawings. The following describes a manner of disposing a heat pipe in the heat dissipation module 100 with reference to some other accompanying drawings.

FIG. 4A is a schematic assembly diagram of a to-be-heat-dissipated part, a first pipe section, and a first cold plate in FIG. 2A.

In some embodiments, as shown in FIG. 4A and with reference to FIG. 2A, the first cold plate 30 and a first pipe section 51 are used as examples in FIG. 4A for illustration. However, a connection relationship between the second cold plate 40 and a second pipe section 52 is the same as a connection structure between the first cold plate 30 and the first pipe section 51. With reference to FIG. 4A, for example, in FIG. 4A, the first cold plate 30 may be replaced with the second cold plate 40, and the first pipe section 51 may be replaced with the second pipe section 52.

Any heat pipe 50 in the heat dissipation module 100 in this embodiment includes a first pipe section 51 and a second pipe section 52 that are connected. The first pipe section 51 is in contact with the first cold plate 30, and the second pipe section 52 is in contact with the second cold plate 40. Therefore, some heat on the first cold plate 30 may be absorbed by using the first pipe section 51, and then the some heat may be released to the second cold plate 40 by using the second pipe section 52.

It may be understood that in some embodiments, FIG. 4A may be a schematic assembly diagram of a to-be-heat-dissipated part, a first pipe section, and a first cold plate in FIG. 2A. In some other embodiments, FIG. 4A may alternatively be a schematic assembly diagram of a to-be-heat-dissipated part, a first pipe section, and a first cold plate in FIG. 2B. That is, regardless of whether the first cold plate 30 and the second cold plate 40 in the heat dissipation module 100 are connected in series or in parallel, assembly of the to-be-heat-dissipated part, the first pipe section, and the first cold plate may be disposed as above.

In still some other embodiments, as shown in FIG. 4A, the first pipe section 51 is in contact with the contact surface 000 of the first cold plate 30, so that the first pipe section 51 of the heat pipe 50 can better absorb heat that is on the to-be-heat-dissipated part 300 and that is absorbed by the first cold plate 30. This can also help subsequently conduct the some heat to the second cold plate 40, to jointly perform heat dissipation for the to-be-heat-dissipated part 300 by using the first cold plate 30 and the second cold plate 40, and improve a heat dissipation effect of the heat dissipation module 100.

For example, a thermally conductive material is disposed on the contact surface 000 of the first cold plate 30. The first pipe section 51 is disposed in contact with the thermally conductive material of the contact surface 000 of the first cold plate 30, so that the first pipe section 51 of the heat pipe 50 can better absorb heat that is on the to-be-heat-dissipated part 300 and that is absorbed by the first cold plate 30. This can also help subsequently conduct the some heat to the second cold plate 40, to jointly perform heat dissipation for the to-be-heat-dissipated part 300 by using the first cold plate 30 and the second cold plate 40, and improve a heat dissipation effect of the heat dissipation module 100. For example, the thermally conductive material may be a material such as stainless steel, copper, or aluminum. This is not limited in this embodiment of this application.

It may be understood that a thermally conductive material is disposed on a side that is of the second cold plate 40 and that is close to the first cold plate 30. The second pipe section 52 may be in contact with the thermally conductive material on the side that is of the second cold plate 40 and that is close to the first cold plate 30, so that the heat pipe 50 can better conduct heat to the second cold plate 40, to jointly perform heat dissipation for the to-be-heat-dissipated part 300 by using the first cold plate 30 and the second cold plate 40, and improve a heat dissipation effect of the heat dissipation module 100. For example, the thermally conductive material may be a material such as stainless steel, copper, or aluminum. This is not limited in this embodiment of this application.

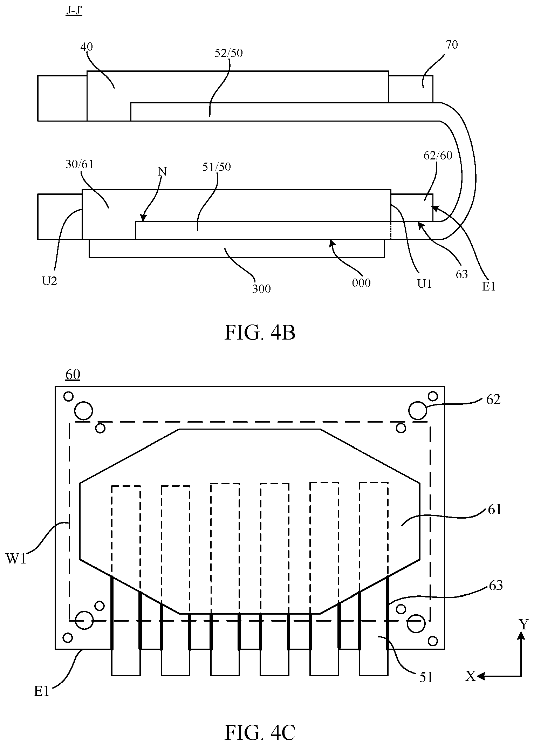

FIG. 4B is a cross-sectional view in a direction J-J' in FIG. 2A.

In some examples, as shown in FIG. 4A and FIG. 4B, the contact surface 000 of the first cold plate 30 includes a recessed region N, and the first pipe section 51 of the heat pipe 50 is located in the recessed region N. The first pipe section 51 may be better fastened, so that the first pipe section 51 of the heat pipe 50 is in contact with the contact surface 000 of the first cold plate 30, and the first pipe section 51 can better absorb the heat that is on the to-be-heat-dissipated part 300 and that is absorbed by the first cold plate 30.

In some other examples, as shown in FIG. 4A, a pipe diameter of the first pipe section 51 is equal to a depth of the recessed region N. In this way, when the first pipe section 51 is located inside the recessed region N, a side that is of the first pipe section 51 and that is close to the to-be-heat-dissipated part 300 and a side that is of a position other than the recessed region N on the first cold plate 30 and that is close to the to-be-heat-dissipated part 300 are located on a same horizontal plane. This can help reduce a spacing between the first cold plate 30 and the to-be-heat-dissipated part 300, better absorb the heat on the to-be-heat-dissipated part 300, and perform heat dissipation processing for the to-be-heat-dissipated part 300. In addition, it can be more convenient to fasten positions of the first cold plate 30 and the to-be-heat-dissipated part 300, to improve structural stability of the heat dissipation module 100.

For example, in FIG. 4A, an example in which a cross-section of the recessed region N is a square is used for illustration. It may be understood that in some other examples, the cross-section of the recessed region N may alternatively be n-shaped, so that it can be more convenient for the first pipe section 51 to engage with the recessed region N.

In FIG. 4A, an example in which one first pipe section 51 is correspondingly prevented in one recessed region N is used for illustration. It may be understood that in some other embodiments, a plurality of first pipe sections 51 may alternatively be correspondingly prevented in one recessed region N, and a fastening material may be added to the recessed region N to fasten the plurality of first pipe sections 51. For example, colloid may be used.

In some embodiments, as shown in FIG. 4B and with reference to FIG. 2A, the first cold plate 30 includes a first edge U1 and a second edge U2 that are opposite to each other. The first cold plate 30 further includes a third edge U3 located between the first edge U1 and the second edge U2. A length of the first edge U1 is greater than a length of the third edge U3. The heat pipe 50 further includes a third pipe section 53, and the third pipe section 53 communicates between the first pipe section 51 and the second pipe section 52. The third pipe section 53 is located on a side that is of the first edge U1 and that is away from the second edge U2.

Because the heat dissipation module 100 includes at least one heat pipe 50, and the length of the first edge U1 is greater than the length of the third edge U3, the third pipe section 53 is disposed to be located on the side that is of the first edge U1 and that is away from the second edge U2. That is, this may also be understood that the heat pipe 50 is concentrated on a relatively long side surface of the heat dissipation module 100. In such an arrangement, a volume of the heat dissipation module 100 is reduced, miniaturization of the heat dissipation module 100 is facilitated, and costs of the heat dissipation module 100 can be lowered. In addition, the heat pipe 50 is concentrated and disposed on a relatively long side surface, so that arrangement of the heat pipe 50 can be facilitated, and a quantity and positions of heat pipes 50 can be flexibly set.

In some examples, two ends of the third edge U3 may be respectively connected to the first edge U1 and the second edge U2. It may be understood that in some other examples, as shown in FIG. 2A, the third edge U3 may be connected to the second edge U2 through another edge. This is not limited in this embodiment of this application.

In some examples, the first edge U1 and the second edge U2 are relatively parallel, and the length of the first edge U1 is equal to a length of the second edge U2. The lengths of the first edge U1 and the second edge U2 that are opposite to each other are equal, to help simplify a cold plate manufacturing process.

It may be understood that in some other embodiments, the length of the first edge U1 may be set to be equal to the length of the third edge U3. When lengths of edges of the first cold plate 30 are equal, a plurality of heat pipes may be concentrated and disposed on one side of any edge. This can reduce a volume of the heat dissipation module 100, and facilitate miniaturization of the heat dissipation module 100.

In some embodiments, as shown in FIG. 4A and with reference to FIG. 2A, there are a plurality of heat pipes 50. The plurality of heat pipes 50 are sequentially disposed at an interval in an extension direction X of one side edge of the first cold plate 30. For example, the plurality of heat pipes 50 are sequentially disposed at an interval in an extension direction X of the first edge U1.

In this embodiment, the heat dissipation module 100 includes a plurality of heat pipes 50. The heat on the first cold plate 30 is conducted to the second cold plate 40 by using the plurality of heat pipes 50. This can help shorten a heat dissipation time required for conducting the heat on the first cold plate 30 to the second cold plate 40. That is, a heat dissipation time required by the heat dissipation module 100 is shortened, and the heat dissipation effect of the heat dissipation module 100 is improved. In addition, it is set that the plurality of heat pipes 50 are sequentially disposed at an interval in the extension direction X of the first edge U1, to avoid a case in which adjacent heat pipes 50 are in contact with and affect each other, that is, avoid a case in which an effect of conducting the heat on the first cold plate 30 to the second cold plate 40 by the heat pipe 50 is affected.

In some examples, the heat dissipation module 100 includes a plurality of heat pipes 50. The plurality of heat pipes 50 are sequentially disposed at an equal interval in an extension direction X of the first edge U1, to facilitate position arrangement of the first pipe section 51 and the second pipe section 52 of the heat pipe 50, simplify a structure of the heat dissipation module 100, and facilitate manufacturing.

In some embodiments, as shown in FIG. 4B, a plane parallel to the contact surface 000 (as shown in FIG. 4A) is used as a reference plane. An orthographic projection of the second cold plate 40 on the reference plane coincides with an orthographic projection of the first cold plate 30 on the reference plane.

It should be noted that "substantial coincidence" includes absolute coincidence and approximate coincidence. That is, if a floating range of a gap between the orthographic projection of the first cold plate 30 on the reference plane and the orthographic projection of the second cold plate 40 on the reference plane does not exceed an error threshold, it may be considered that edges of the two pipe sections approximately coincide.

In such an arrangement, a volume of the heat dissipation module 100 is reduced, miniaturization of the heat dissipation module 100 is facilitated, and costs of the heat dissipation module 100 can be lowered.

In some examples, as shown in FIG. 4B, the first pipe section 51 is in contact with the first cold plate 30, and the second pipe section 52 is in contact with the second cold plate 40. The heat pipe 50 further includes a third pipe section 53 configured to communicate with the first pipe section 51 and the second pipe section 52.

For example, a side that is of the third pipe section 53 and that is close to the first pipe section 51 and a side that is of the third pipe section 53 and that is close to the second pipe section 52 may be arc-shaped pipes. For example, the third pipe section 53 is a C-shaped pipe, to help the third pipe section 53 communicate with the first pipe section 51 and the second pipe section 52, so that the heat pipe is used to conduct some heat on the first cold plate 30 to the second cold plate 40, and the first cold plate 30 and the second cold plate 40 are simultaneously used to perform heat dissipation for a heat source.

In some embodiments, as shown in FIG. 4B, an orthographic projection of the first pipe section 51 on a plane on which the first cold plate 30 is located substantially coincides with an orthographic projection of the second pipe section 52 on the plane o which the first cold plate 30 is located. In such an arrangement, it is convenient to dispose the third pipe section 53 communicating with the first pipe section 51 and the second pipe section 52, thereby simplifying process difficulty of the heat pipe 50.

It should be noted that "substantial coincidence" includes absolute coincidence and approximate coincidence. That is, if a floating range of a gap between the orthographic projection of the first pipe section 51 on the plane on which the first cold plate 30 is located and the orthographic projection of the second pipe section 52 on the plane o which the first cold plate 30 is located does not exceed an error threshold, it may be considered that edges of the two pipe sections approximately coincide.

The following describes other structures in the heat dissipation module with reference to some related accompanying drawings. First, the following describes a structure of the first cold plate bracket 60 in the heat dissipation module 100 with reference to some related accompanying drawings.

FIG. 4C is a schematic assembly diagram of a first cold plate bracket and a first pipe section of a heat pipe in FIG. 2A.

In some embodiments, as shown in FIG. 4C and with reference to FIG. 2A, the first cold plate bracket 60 includes a first hollow region 61 and a first connection portion 62 surrounding the first hollow region 61. The first cold plate 30 is mounted in the first hollow region 61.

In this embodiment, the first cold plate 30 is mounted in the first hollow region 61. Therefore, the first cold plate 30 may be fastened by using the first hollow region 61 in the first cold plate bracket 60. In addition, an outer side edge of the first connection portion 62 may be configured to be connected to an external structure. The external structure may be a base, a bracket, or the like in the electronic device 200. Further, the first cold plate bracket 60 may be fastened by using the external structure, and then the first cold plate 30 may be fastened by using the first hollow region 61 in the first cold plate bracket 60. This can help improve stability of the first cold plate bracket 60, that is, this can help improve stability of the heat dissipation module 100. In some examples, the external structure may reuse an original structure in the electronic device 200. In some other examples, the external structure may alternatively be another fixed structure disposed in the electronic device 200.

In such an arrangement, the contact surface 000 of the first cold plate 30 may be in contact with the to-be-heat-dissipated part 300. Therefore, the first cold plate 30 can absorb the heat on the to-be-heat-dissipated part 300, and perform cooling processing for the to-be-heat-dissipated part 300.

In some embodiments, as shown in FIG. 4C, the first hollow region 61 may be located in a middle portion W1 of the first cold plate bracket 60. Further, the first hollow region 61 may be used to limit the first cold plate 30 to be located in the middle portion W1 of the first cold plate bracket 60. This can ensure even force distribution on the first cold plate bracket 60. In addition, this also helps simplify process difficulty of the first cold plate bracket 60.

In some embodiments, as shown in FIG. 4B and FIG. 4C, the first cold plate bracket 60 further includes a first heat pipe mounting hole 63 extending from a first side surface E1 of the first cold plate bracket 60 to the first hollow region 61. The first heat pipe mounting hole 63 is disposed to facilitate mounting and fastening of the first pipe section 51 of the heat pipe 50. It is set that the first pipe section 51 extends into the first hollow region 61 through the first heat pipe mounting hole 63, to prevent misalignment between the first pipe section 51 and the contact surface 000 of the first cold plate 30, that is, ensure that the first pipe section 51 may be in contact with the contact surface 000 of the first cold plate 30. Further, the heat pipe 50 may absorb heat on the first cold plate 30 by using the first pipe section 51, and partially conduct heat that is on the to-be-heat-dissipated part 300 and that is absorbed by the heat pipe 50 to the second cold plate 40. Therefore, the first cold plate 30 and the second cold plate 40 are simultaneously used to perform heat dissipation for the heat source, to help improve a heat dissipation effect of the heat dissipation module 100.

In some embodiments, as shown in FIG. 4B and FIG. 4C, an example in which an end that is of the first heat pipe mounting hole 63 and that is away from the first side surface E1 is located inside the first hollow region 61 is used for illustration.

It may be understood that in some other embodiments, it may alternatively be set that an end that is of the first heat pipe mounting hole 63 and that is away from the first side surface E1 is flush with a side that is of the first hollow region 61 and that is away from the first side surface E1. In this embodiment, compared with that shown in FIG. 4B and FIG. 4C, the solution in which the end that is of the first heat pipe mounting hole 63 and that is away from the first side surface E1 is located inside the first hollow region 61 can help increase an overlapping area between the first heat pipe mounting hole 63 and the first hollow region 61, that is, can help increase a contact area between the first pipe section 51 and the first cold plate 30, so that the first pipe section 51 can better absorb heat on the first cold plate 30, and partially conduct heat that is on the to-be-heat-dissipated part 300 and that is absorbed by the first pipe section 51 to the second cold plate 40. The first cold plate 30 and the second cold plate 40 are simultaneously used to perform heat dissipation for the heat source, to help improve a heat dissipation effect of the heat dissipation module 100.

However, this is not limited in this embodiment of this disclosure, provided that it is ensured that there is an overlapping region between the first heat pipe mounting hole 63 and the first hollow region 61, that is, the first pipe section 51 can be in contact with the first cold plate 30.

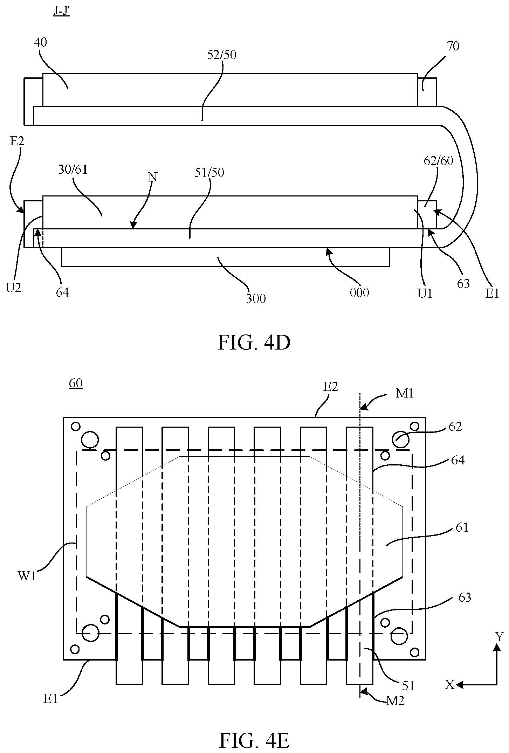

FIG. 4D is another cross-sectional view in a direction J-J' in FIG. 2A. FIG. 4E is another schematic assembly diagram of a first cold plate bracket and a first pipe section of a heat pipe in FIG. 2A.

In some other embodiments, as shown in FIG. 4D and FIG. 4E and with reference to FIG. 4B, the first cold plate bracket 60 may further include a first extension hole 64. The first extension hole 64 extends from the first hollow region 61 to a direction facing away from the first side surface E1, and an axis M1 of the first extension hole 64 substantially coincides with an axis M2 of the first heat pipe mounting hole 63, to prevent misalignment between the first heat pipe mounting hole 63 and the first extension hole 64. Therefore, the first pipe section 51 may sequentially extend into the first extension hole 64 through the first heat pipe mounting hole 63 and the first hollow region 61. That is, two ends of the first pipe section 51 may separately protrude from the first hollow region 61, and are located in the first heat pipe mounting hole 63 and the first extension hole 64, to fasten and support the first pipe section 51, so as to avoid a problem that the first pipe section 51 sinks due to gravity of the first pipe section 51.

It should be noted that "substantial coincidence" includes absolute coincidence and approximate coincidence. That is, if a floating range of a gap between the axis M1 of the first extension hole 64 and the axis M2 of the first heat pipe mounting hole 63 does not exceed an error threshold, it may be considered that the axis M1 of the first extension hole 64 approximately coincides with the axis M2 of the first heat pipe mounting hole 63.

In this embodiment of this application, a degree to which the first extension hole 64 extends from the first hollow region 61 to a side facing away from the first side surface E1 is not limited, provided that it is ensured that a side that is of the first pipe section 51 and that faces away from the first side surface E1 protrudes from the first hollow region 61.

In some examples, the first extension hole 64 extends to a second side surface E2 of the first cold plate bracket 60. The second side surface E2 and the first side surface E1 are disposed opposite to each other in a direction Y. The direction Y is parallel to the contact surface 000, and the direction X and the direction Y intersect. This can further fasten the first pipe section 51, to avoid a problem that the first pipe section 51 sinks due to gravity of the first pipe section 51.

In some examples, the direction X is perpendicular to the direction Y. It may be understood that in some other embodiments, the direction X and the direction Y intersect to form an angle, and the angle may be an acute angle or an obtuse angle.

In some examples, as shown in FIG. 4C and FIG. 4E, a side that is of the first connection portion 62 and that is close to the first hollow region 61 further includes a first protruding edge (not shown in the figure), and the first protruding edge is disposed around the first cold plate 30. The first protruding edge may support the first cold plate 30. A specific structure of the first protruding edge is not limited in this embodiment of this application, and the first protruding edge may be in a closed shape. The first protruding edge may alternatively be a plurality of protruding blocks disposed at an interval around the first cold plate 30.

In still some other examples, the first cold plate 30 may be snap-fitted with the first hollow region 61, or the first cold plate 30 may be bolted to the first cold plate bracket 60. In this case, whether the first connection portion 62 is mounted with the first protruding edge is not limited in this embodiment. That is, the first connection portion 62 may be provided with the first protruding edge, or may not be provided with the first protruding edge.

To clearly illustrate a specific internal structure of the first cold plate bracket 60, the first cooling pipeline 10 and the second cooling pipeline 20 with which the first cold plate 30 needs to communicate are not shown in FIG. 4C and FIG. 4E. For specific structures of the first cooling pipeline 10 and the second cooling pipeline 20, refer to FIG. 2A.

In addition, in FIG. 4C and FIG. 4E, an example in which the first hollow region 61 is in a shape of an octagon is used for illustration. It may be understood that in some other embodiments, the first hollow region 61 may alternatively be set to be in a shape of an ellipse or a square. This may be specifically adjusted and set based on a shape of the first cold plate 30.

In the foregoing embodiment, an example in which FIG. 4B to FIG. 4E are applicable to the heat dissipation module 100 shown in FIG. 2A is used for illustration. It may be understood that in some other embodiments, FIG. 4B to FIG. 4E are applicable to the heat dissipation module 100 shown in FIG. 2B. That is, regardless of whether the first cold plate 30 and the second cold plate 40 in the heat dissipation module 100 are connected in series or in parallel, the structure of the first cold plate bracket 60 and a structure of the second cold plate bracket 70 in the heat dissipation module 100 may be disposed as above.

In the foregoing embodiment, the structure of the first cold plate bracket 60 is described in detail with reference to FIG. 4B to FIG. 4E. The structure of the second cold plate bracket may be the same as the structure of the first cold plate bracket 60. Therefore, for the structure of the second cold plate bracket, refer to FIG. 4B to FIG. 4E.

For example, the second cold plate bracket 70 includes a second hollow region and a second connection portion surrounding the second hollow region. The second cold plate is mounted in the second hollow region.

A structure of the second hollow region may be the same as a structure of the first hollow region 61. A difference between the second hollow region and the first hollow region 61 lies in that the second hollow region is used to mount the second cold plate 40. A structure of the second connection portion may be the same as a structure of the first connection portion 62. A difference between the second connection portion and the first connection portion 62 lies in that the second connection portion is configured to fasten the second cold plate.

For example, the second cold plate bracket further includes a second heat pipe mounting hole extending from a second side surface of the second cold plate bracket to the second hollow region. The second pipe section extends into the second hollow region through the second heat pipe mounting hole, so that the third pipe section is in contact with the second cold plate.

A structure of the second heat pipe mounting hole may be the same as a structure of the first heat pipe mounting hole 63. A difference between the second heat pipe mounting hole and the first heat pipe mounting hole 63 lies in that the second heat pipe mounting hole is configured to fasten the second pipe section 52 of the heat pipe 50.

For example, the second cold plate bracket further includes a second extension hole, the second extension hole extends from the second hollow region to a direction facing away from the third side surface, and an axis of the second extension hole coincides with an axis of the second heat pipe mounting hole.

A structure of the second extension hole may be the same as a structure of the first extension hole 64. A difference between the second extension hole and the first extension hole 64 lies in that the second extension hole is configured to fasten the second pipe section 52 of the heat pipe 50.

In the foregoing some embodiments, an example in which the first cold plate bracket 60 and the second cold plate bracket are of a same structure is used for illustration. It may be understood that in some other embodiments, the structure of the first cold plate bracket 60 may alternatively be different from the structure of between the second cold plate 70, provided that the contact surface of the first cold plate 30 can be in contact with the to-be-heat-dissipated part, and the heat pipe 50 is connected to the first cold plate 30 and the second cold plate 40. This is not limited in this embodiment of this disclosure.

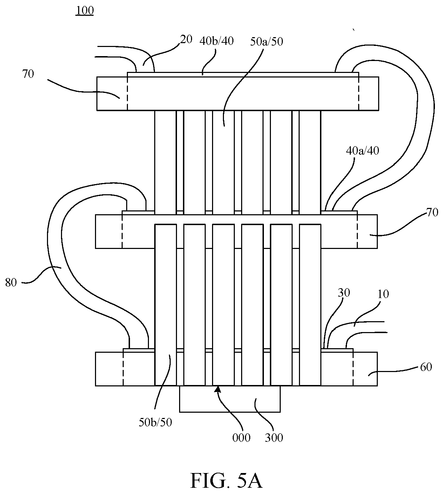

FIG. 5A is a schematic diagram of a structure of a heat dissipation module with a plurality of second cold plates according to some embodiments of this application.

In still some embodiments, as shown in FIG. 5A, there are a plurality of second cold plates 40. The plurality of second cold plates 40 are sequentially arranged in a direction away from the first cold plate 30. When there are a plurality of second cold plates 40, the heat dissipation module 100 further includes a third cooling pipeline 80, configured to enable the plurality of cold plates in the heat dissipation module 100 to communicate with each other.

As shown in FIG. 5A, an example in which the heat dissipation module 100 includes two second cold plates 40, the first cold plate 30 and a first second cold plate 40a are connected in series, and the second cold plate 40a is further connected in series to a second cold plate 40b adjacent to the second cold plate 40a is used for illustration. In this case, the first cooling pipeline 10 communicates with the first cold plate 30. The first cold plate 30 communicates with the second cold plate 40a through the third cooling pipeline 80. The second cold plate 40a communicates with the second cold plate 40b through the third cooling pipeline 80. In addition, the second cold plate 40b communicates with the second cooling pipeline 20, so that the first cold plate 30, the second cold plate 40a, and the second cold plate 40b are connected in series and communicate between the first cooling pipeline 10 and the second cooling pipeline 20.

In such an arrangement, the heat dissipation module 100 may include three or more cold plates. A plurality of cold plates are used to simultaneously perform heat dissipation for the to-be-heat-dissipated part 300. This can help reduce thermal resistance in the heat dissipation module 100, and improve the heat dissipation effect of the heat dissipation module 100.

In some examples, as shown in FIG. 5A, when the heat dissipation module 100 may include three or more cold plates, for example, the heat dissipation module 100 includes two second cold plates 40 and the first cold plate 30, the heat dissipation module 100 includes two heat pipes 50. The two second cold plates 40 are a second cold plate 40a and a second cold plate 40b, and the two heat pipes are a heat pipe 50a and a heat pipe 50b. Two ends of the heat pipe 50a are respectively in contact with the first cold plate 30 and the second cold plate 40a. The heat pipe 50b is separately in contact with the second cold plate 40a and the second cold plate 40b.

In FIG. 5A, an example in which the heat pipe 50a and the heat pipe 50b are respectively located on two side edges of the heat dissipation module 100 is used for illustration. The heat pipe 50a and the heat pipe 50b are disposed on different side edges of the heat dissipation module 100, to avoid a case in which the heat dissipation effect of the heat dissipation module 100 is reduced because the heat pipe 50a and the heat pipe 50b affect each other.

It may be understood that in some other embodiments, the heat pipe 50a and the heat pipe 50b may alternatively be located on a same side of the heat dissipation module 100. The heat pipe 50a and the heat pipe 50b are disposed on a same side edge of the heat dissipation module 100. This can reduce a volume of the heat dissipation module, and facilitate miniaturization of the heat dissipation module. A relative position relationship between a plurality of heat pipes 50 is not specifically limited in this embodiment of this application.

In some other embodiments, as shown in FIG. 5A, the plurality of second cold plates 40 are sequentially arranged in a direction away from the first cold plate 30, to avoid a case in which the heat dissipation effect of the heat dissipation module 100 is affected because the plurality of second cold plates 40 are in direct contact with each other, heat affects each other, and the heat cannot be well discharged to the outside of the heat dissipation module 100.

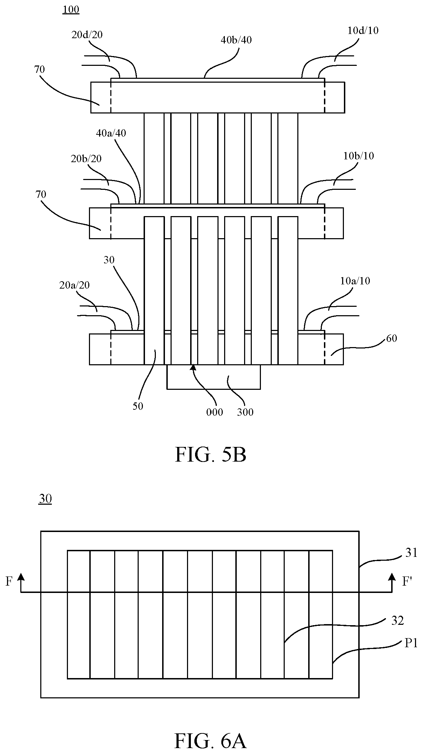

FIG. 5B is a schematic diagram of a structure of a heat dissipation module with a plurality of second cold plates according to some other embodiments of this application.

In still some embodiments, as shown in FIG. 5B, there are a plurality of second cold plates 40. The plurality of second cold plates 40 are sequentially arranged in a direction away from the first cold plate 30.

A difference from FIG. 5A is that an example in which the heat dissipation module 100 includes two second cold plates 40, the first cold plate 30 and a first second cold plate 40a are connected in parallel, and the second cold plate 40a is further connected in parallel to a second cold plate 40b adjacent to the second cold plate 40a is used for illustration. In this case, the first cooling pipeline 10 further includes a fifth branch pipe 10d in addition to the first branch pipe 10a and the second branch pipe 10b, and the second cooling pipeline 20 further includes a sixth branch pipe 20d in addition to the third branch pipe 20a and the fourth branch pipe 20b.

In this case, the first branch pipe 10a in the first cooling pipeline 10 communicates with an inlet of the first cold plate 30, and the third branch pipe 20a in the second cooling pipeline 20 communicates with an outlet of the first cold plate 30. The second branch pipe 10b in the first cooling pipeline 10 communicates with an inlet of the second cold plate 40a, and the fourth branch pipe 20b in the second cooling pipeline 20 communicates with an outlet of the second cold plate 40a. The fifth branch pipe 10d in the first cooling pipeline 10 communicates with an inlet of the second cold plate 40b, and the sixth branch pipe 20d in the second cooling pipeline 20 communicates with an outlet of the second cold plate 40b. In addition, the first branch pipe 10a, the second branch pipe 10b, and the fifth branch pipe 10d communicate with a common main pipeline, and the third branch pipe 20a, the fourth branch pipe 20b, and the sixth branch pipe 20d communicate with a common main pipeline, so that the first cold plate 30, the second cold plate 40a, and the second cold plate 40b are connected in parallel and communicate between the first cooling pipeline 10 and the second cooling pipeline 20.

In such an arrangement, the heat dissipation module 100 may include three or more cold plates. A plurality of cold plates are used to simultaneously perform heat dissipation for the to-be-heat-dissipated part 300. This can help reduce thermal resistance in the heat dissipation module 100, and improve the heat dissipation effect of the heat dissipation module 100.

In some examples, as shown in FIG. 5B, when the heat dissipation module 100 may include three or more cold plates, for example, the heat dissipation module 100 includes two second cold plates 40 and the first cold plate 30, the heat dissipation module 100 includes two heat pipes 50. The two second cold plates 40 are a second cold plate 40a and a second cold plate 40b, and the two heat pipes are a heat pipe 50a and a heat pipe 50b. Two ends of the heat pipe 50a are respectively in contact with the first cold plate 30 and the second cold plate 40a. The heat pipe 50b is separately in contact with the second cold plate 40a and the second cold plate 40b.

In FIG. 5B, an example in which the heat pipe 50a and the heat pipe 50b are respectively located on two side edges of the heat dissipation module 100 is used for illustration. The heat pipe 50a and the heat pipe 50b are disposed on different side edges of the heat dissipation module 100, to avoid a case in which the heat dissipation effect of the heat dissipation module 100 is reduced because the heat pipe 50a and the heat pipe 50b affect each other.

It may be understood that in some other embodiments, the heat pipe 50a and the heat pipe 50b may alternatively be located on a same side of the heat dissipation module 100. The heat pipe 50a and the heat pipe 50b are disposed on a same side edge of the heat dissipation module 100. This can reduce a volume of the heat dissipation module, and facilitate miniaturization of the heat dissipation module. A relative position relationship between a plurality of heat pipes 50 is not specifically limited in this embodiment of this application.

In some other embodiments, as shown in FIG. 5B, the plurality of second cold plates 40 are sequentially arranged in a direction away from the first cold plate 30, to avoid a case in which the heat dissipation effect of the heat dissipation module 100 is affected because the plurality of second cold plates 40 are in direct contact with each other, heat affects each other, and the heat cannot be well discharged to the outside of the heat dissipation module 100.

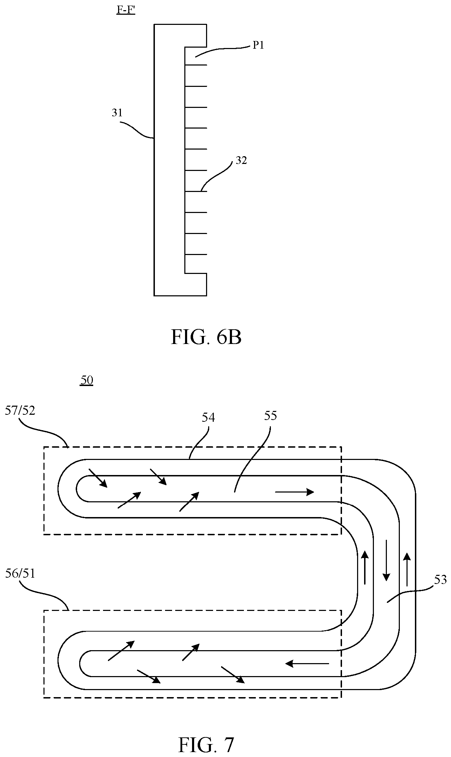

FIG. 6A is a schematic diagram of a structure of a first cold plate in FIG. 2A. FIG. 6B is a cross-sectional view in a direction F-F' in FIG. 6A.

In some embodiments, as shown in FIG. 6A and FIG. 6B, the first cold plate 30 includes a first housing 31 and a first fin assembly 32, the first housing 31 has a first accommodating cavity P1, and the first fin assembly 32 is located in the first accommodating cavity P1. The first fin assembly 32 is disposed in the first cold plate 30. This can help improve the heat dissipation effect of the first cold plate 30, that is, this can improve the heat dissipation effect of the heat dissipation module 100.

In some examples, the first fin assembly 32 includes a plurality of first fins. In FIG. 6A and FIG. 6B, an example in which 10 first fins are included is used for illustration. However, a quantity and an arrangement manner of first fins are not specifically limited in this embodiment of this application.

In FIG. 6A, the structure of the first cold plate is used as an example for illustration. A structure of the second cold plate may be the same as the structure of the first cold plate. Therefore, for the structure of the second cold plate, refer to FIG. 6A.

For example, the second cold plate includes a second housing and a second fin assembly. A structure of the second housing may be the same as a structure of the first housing. For the structure of the second housing, refer to the foregoing descriptions of the structure of the first housing. In addition, a structure of the second fin assembly may be the same as a structure of the first fin assembly. For the structure of the second fin assembly, refer to the foregoing descriptions of the structure of the first fin assembly.

In the foregoing embodiment, an example in which FIG. 6A is a schematic diagram of the structure of the first cold plate in FIG. 2A is used for illustration. It may be understood that in some other embodiments, FIG. 6A may alternatively be a schematic diagram of a structure of a first cold plate in FIG. 2B. That is, regardless of whether the first cold plate 30 and the second cold plate 40 in the heat dissipation module 100 are connected in series or in parallel, this is applicable to the structure of the first cold plate. Certainly, this is also applicable to the structure of the second cold plate.

The following describes an internal structure of the heat pipe in the heat dissipation module 100 with reference to related accompanying drawings.

FIG. 7 is a schematic diagram of a structure of a heat pipe in FIG. 2A.

In some embodiments, as shown in FIG. 7, the heat pipe 50 includes a pipe shell 54, a wick 55, and a working substance. The wick 55 is located on an inner wall of the pipe shell 54, and the working substance is located in the pipe shell 54. The first pipe section 51 of the heat pipe 50 may be an evaporator pipe section, and the second pipe section 52 may be a condenser pipe section. The evaporator pipe section is configured to evaporate a liquid working substance into a vapor working substance. The condenser pipe section is configured to condense a vapor working substance into a liquid working substance.

It may be understood that when the first pipe section 51 is heated, the working substance in the first pipe section 51 can absorb heat and evaporate. Driven by atmospheric pressure, the working substance can flow to the second pipe section 52 through the third pipe section 53, and the working substance condenses in the second pipe section 52, to release heat.

It should be noted that in this embodiment of this application, only an example in which for the first pipe section 51, a vapor working substance is input and a liquid working substance is output and for the second pipe section 52, a liquid working substance is input and a liquid working substance is output is used for illustration.

In some examples, when the heat pipe 50 is used, the second pipe section 52 is located above the first pipe section 51 in a gravity direction, so that the liquid working substance in the pipe shell 54 can flow to the first pipe section 51 under gravity. This increases a flow speed of the working substance, and therefore improves heat transfer efficiency, that is, improves heat dissipation efficiency of the heat dissipation module 100.

In some examples, the pipe shell 54 may be a seamless metal pipe. For example, the pipe shell 54 may be made of one or more of copper, aluminum, or stainless steel.

In some examples, the pipe shell 54 may be in a standard circular shape, or may be in an irregular shape, for example, an ellipse, a square, a rectangle, a flat shape, or a corrugated pipe.

In the foregoing embodiment, an example in which FIG. 7 is a schematic diagram of the structure of the heat pipe in FIG. 2A is used for illustration. It may be understood that in some other embodiments, FIG. 7 may alternatively be a schematic diagram of a structure of a first cold plate in FIG. 2B. That is, regardless of whether the first cold plate 30 and the second cold plate 40 in the heat dissipation module 100 are connected in series or in parallel, this is applicable to the structure of the heat pipe.

In conclusion, some embodiments of this application provide a heat dissipation module 100 and an electronic device 200. When the heat dissipation module 100 is used, a first cold plate 30 communicates between a first cooling pipeline 10 and a second cooling pipeline 20. A cooling working substance may flow into the first cold plate 30 through the first cooling pipeline 10. After the first cold plate 30 absorbs heat on a to-be-heat-dissipated part 300, the heat is discharged to the outside of the first cold plate 30 through the second cooling pipeline 20.

In addition, a first pipe section 51 of any heat pipe 50 is in contact with the first cold plate 30, and a second pipe section 52 of the heat pipe 50 is in contact with the second cold plate 40. Therefore, some heat on the first cold plate 30 may be absorbed by using the first pipe section 51, the heat absorbed by the first pipe section 51 may be transferred by using a third pipe section 53, and then the some heat may be released to the second cold plate 40 by using the second pipe section 52. The second cold plate 40 further communicates between the first cooling pipeline 10 and the second cooling pipeline 20. Therefore, the cooling working substance may further flow into the second cold plate 40 through the first cooling pipeline 10, absorb heat on the second cold plate 40, and then be discharged to the outside of the second cold plate 40 through the second cooling pipeline 20. That is, in this case, the heat pipe 50 may be used, so that the second cold plate 40 can share heat that is on the to-be-heat-dissipated part 300 and that is absorbed by the first cold plate 30.

In addition, heat absorbed by the first cold plate 30 and the second cold plate 40 is released with the heated cooling working substance discharged by the first cold plate 30 and the second cold plate 40, to implement heat dissipation for the to-be-heat-dissipated part.

Based on the foregoing descriptions, compared with a case in which only the first cold plate 30 is used to perform heat dissipation for the to-be-heat-dissipated part 300, the heat dissipation module 100 provided in this embodiment of this application may distribute some heat on the to-be-heat-dissipated part 300 to the second cold plate 40. That is, the first cold plate 30 and the second cold plate 40 may be simultaneously used to perform heat dissipation for the to-be-heat-dissipated part 300, to improve a heat dissipation effect of the heat dissipation module 100.

In addition, the electronic device 200 having the heat dissipation module 100 has beneficial effects of the heat dissipation module 100 in any one of the foregoing embodiments. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation module, comprising:
a first cooling pipeline and a second cooling pipeline, wherein the first cooling pipeline is configured to input a cooling working substance, and the second cooling pipeline is configured to output the cooling working substance;
a first cold plate that communicates with the first cooling pipeline and the second cooling pipeline, wherein a contact surface of the first cold plate is in contact with a to-be-heat-dissipated part, and is configured to absorb heat on the to-be-heat-dissipated part;
a second cold plate that communicates with the first cooling pipeline and the second cooling pipeline, wherein the second cold plate is disposed at an interval from the first cold plate;
at least one heat pipe, wherein the heat pipe is connected to the first cold plate and the second cold plate;
a first cold plate bracket, configured to support the first cold plate; and
a second cold plate bracket, configured to support the second cold plate.

2. The heat dissipation module according to claim 1, wherein the second cold plate is located on a side that is of the first cold plate and that faces away from the contact surface.

3. The heat dissipation module according to claim 1 or 2, wherein any heat pipe comprises a first pipe section and a second pipe section that are sequentially connected, the first pipe section is in contact with the first cold plate, and the second pipe section is in contact with the second cold plate.

4. The heat dissipation module according to claim 3, wherein the contact surface of the first cold plate comprises a recessed region, and the first pipe section is located in the recessed region.

5. The heat dissipation module according to any one of claims 1 to 4, wherein the first cold plate bracket comprises a first hollow region and a first connection portion surrounding the first hollow region, and the first cold plate is mounted in the first hollow region; and/or
the second cold plate bracket comprises a second hollow region and a second connection portion surrounding the second hollow region, and the second cold plate is mounted in the second hollow region.

6. The heat dissipation module according to any one of claims 1 to 5, wherein the first cold plate bracket further comprises a first heat pipe mounting hole extending from a first side surface of the first cold plate bracket to the first hollow region; and
the first pipe section extends into the first hollow region through the first heat pipe mounting hole, so that the first pipe section is in contact with the first cold plate;
and/or
the second cold plate bracket further comprises a second heat pipe mounting hole extending from a second side surface of the second cold plate bracket to the second hollow region; and
the second pipe section extends into the second hollow region through the second heat pipe mounting hole, so that the second pipe section is in contact with the second cold plate.

7. The heat dissipation module according to any one of claims 1 to 6, further comprising a third cooling pipeline, wherein an inlet of the first cold plate communicates with the first cooling pipeline, an outlet of the first cold plate communicates with an inlet of the second cold plate through the third cooling pipeline, and an outlet of the second cold plate communicates with the second cooling pipeline.

8. The heat dissipation module according to any one of claims 1 to 6, wherein
the first cooling pipeline comprises a first branch pipe, a second branch pipe, and a first main pipe; and one end of the first branch pipe and one end of the second branch pipe communicate with the first main pipe;
the second cooling pipeline comprises a third branch pipe, a fourth branch pipe, and a second main pipe; and one end of the third branch pipe and one end of the fourth branch pipe communicate with the second main pipe;
an inlet of the first cold plate communicates with the other end of the first branch pipe, and an outlet of the first cold plate communicates with the other end of the third branch pipe; and
an inlet of the second cold plate communicates with the other end of the second branch pipe, and an outlet of the second cold plate communicates with the other end of the fourth branch pipe.

9. The heat dissipation module according to any one of claims 1 to 8, wherein
there are a plurality of heat pipes, and the plurality of heat pipes are sequentially disposed at an interval in an extension direction of one side edge of the first cold plate.

10. The heat dissipation module according to any one of claims 1 to 9, wherein
a plane parallel to the contact surface is used as a reference plane; and
an orthographic projection of the second cold plate on the reference plane coincides with an orthographic projection of the first cold plate on the reference plane.

11. The heat dissipation module according to any one of claims 1 to 10, wherein
there are a plurality of second cold plates, and the plurality of second cold plates are sequentially arranged in a direction away from the first cold plate.

12. The heat dissipation module according to any one of claims 1 to 11, wherein
the first cold plate comprises a first housing and a first fin assembly, the first housing has a first accommodating cavity, and the first fin assembly is located in the first accommodating cavity; and/or
the second cold plate comprises a second housing and a second fin assembly, the second housing has a second accommodating cavity, and the second fin assembly is located in the second accommodating cavity.

13. An electronic device, comprising:
at least one to-be-heat-dissipated part; and
at least one heat dissipation module according to any one of claims 1 to 12, wherein a contact surface of a first cold plate in the heat dissipation module is in contact with the at least one to-be-heat-dissipated part.

14. The electronic device according to claim 13, wherein an area of the contact surface of the first cold plate in the heat dissipation module is greater than or equal to an area of a surface that is of one to-be-heat-dissipated part and that is close to the heat dissipation module.
